(19) Europäisches Patentamt
European Patent Office
Office européen des brevets

(11) **EP 2 703 830 B1**

(12) **EUROPÄISCHE PATENTSCHRIFT**

(45) Veröffentlichungstag und Bekanntmachung des Hinweises auf die Patenterteilung:
**09.10.2019 Patentblatt 2019/41**

(51) Int Cl.:
***G01R 31/382*** *(2019.01)*

(21) Anmeldenummer: **13003594.2**

(22) Anmeldetag: **17.07.2013**

(54) **Vorrichtung und Verfahren zur qualitativen Bestimmung des Betriebszustandes einer Batterie**

Device and method for qualitative determination of the operational state of a battery

Dispositif et procédé de détermination qualitative de l'état de fonctionnement d'une batterie

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.08.2012 DE 102012016837**

(43) Veröffentlichungstag der Anmeldung:
**05.03.2014 Patentblatt 2014/10**

(73) Patentinhaber: **Forschungszentrum Jülich GmbH 52425 Jülich (DE)**

(72) Erfinder:
• **Wackerl, Jürgen
  50829 Köln (DE)**
• **Bergholz, Timm
  50226 Frechen (DE)**
• **Korte, Carsten
  52428 Jülich (DE)**
• **Nunez, Theodor
  Howard, Villas de Howand A-1 (PA)**

(56) Entgegenhaltungen:
**WO-A1-2009/146547     WO-A2-2012/092467**

## Beschreibung

Die Erfindung betrifft ein Verfahren, mit dem berührungslos und zerstörungsfrei Eigenschaften von elektrochemischen Zellen während des Betriebs, insbesondere Batterien, detektiert werden können. Zu diesen detektierbaren Eigenschaften gehören insbesondere die Kontrolle des Ladezustands oder die Verfolgung von Alterungsvorgängen. Ferner betrifft die Erfindung eine Vorrichtung zur Durchführung des vorgenannten Verfahrens.

Stand der Technik

Derzeit existieren nur wenige nicht invasive Messmethoden, mit denen unterschiedliche Eigenschaften einer elektrochemischen Zelle, z. B. einer Batterie überprüft werden können.

So liefert eine Röntgenuntersuchung an einer Batterie lediglich Informationen zur Dichteverteilung und somit zur geometrischen Anordnung von Komponenten eines Prüfobjektes, z. B. einer Batterie. Eine Korrelation mit der tatsächlichen Stromdichteverteilung innerhalb des Prüfobjektes ist nicht möglich.

Eine elektrische Charakterisierung über die Messung der offenen Zellspannung (OCV) einer Batterie liefert Informationen über den Ladungszustand der Batterie, kann jedoch nur im lastfreien Zustand erfolgen. Zudem beinhalten die Ergebnisse keinerlei Informationen bezüglich einer Ortsauflösung.

Die elektrische Charakterisierung mit Hilfe der elektrochemischen Impedanzspektroskopie (EIS) kann integrale Informationen zu Prozess- oder Materialänderungen einer Batterie beisteuern. Auch hier erfolgt keine ortsaufgelöste Detektion. Eine genaue Zuordnung ist dabei jedoch oftmals problematisch.

Eine thermische Charakterisierung der Oberflächentemperatur lässt in gewissem Rahmen Rückschlüsse auf interne Strom- und Wärmeflüsse der Batterie zu. Allerdings werden thermische Messungen häufig durch viele Quereinflüsse anderer Effekte, wie z. B. Reflexionen, gestört und liefern in der Regel ein nur verzögertes und teilweise verschmiertes Signal.

Mit Hilfe einer mechanischen Charakterisierung über die Dilatometrie (DIL) können beispielsweise genaue Messungen von Dimensionsänderungen, d. h. ortsaufgelöste Materialänderungen an Feststoffen erkannt werden. Die Messungen sind jedoch ebenfalls störanfällig und liefern in der Regel nur ein verzögertes Signal. Zudem sind die Messdaten von temperaturbedingten Effekten zusätzlich überlagert.

Als zerstörungsfreie Werkstoffprüfung von magnetisierbaren Bauteilen oder Verbundbauteilen mit magnetisierbarer Matrix ist beispielsweise die Magnettomographie bekannt. So wird in DE 43 42 100 A1 die konfokale Magnettomographie zur Anwendung bei der Detektion von Spaltrissen in Betonbauten vorgeschlagen. In US 7,550,737 B1 und US 7,902,518 B1 werden nicht invasive Untersuchungen an Batterien mit Hilfe der Micro-Computer-Tomographie beschrieben. Zu den dort genannten Tomograhiearten gehören die Computertomographie als spezielles Röntgenverfahren, die Neutronentomographie sowie die Kryoelektronentomographie. Untersucht wurden verschiedene herkömmliche Batterien (alkalische Batterien, Lithium-Ionen-Disulfid-Batterien, Lithium-Ionen-Phosphat-Batterien, Lithium-Mangandioxid-Batterien, Zink und Zink-Kohle-Batterien und auch Nickel-Metallhydrid-Batterien) mit unterschiedlicher Bauart und Leistung. Neben den primären Batterien können auch wiederaufladbare Batterien mit dieser Methode untersucht werden. Mit Hilfe der Tomographie können Aussagen zum inneren geometrischen Aufbau der Batterien gemacht werden, wie beispielsweise die Ausdehnung des Anoden - oder des Kathodenmaterials, die Verteilung und Dichteänderung von Komponenten sowie die Verformung der Batterie während des Entladevorgangs.

Unter dem Begriff Tomographie werden verschiedene bildgebende Verfahren zusammengefasst, welche die innere räumliche Struktur eines Objektes ermitteln und in Form von Schnittbildern (auch Schichtbilder oder Tomogramme genannt) darstellen können.

Aus WO 2012/092467 A2 ist eine Sensoranordnung zur Messung der magnetischen Suszeptibilität bekannt, um den Ladungszustand eines Objektes, insbesondere einer elektrochemischen Zelle, zu bestimmen. Als Stand der Technik wird dort eine Sensoranordnung beschrieben, die einen Ladungssensor mit einem primären Magneten, welcher ein primäres Magnetfeld erzeugt, sowie einen Magnetflusssensor umfasst. Der Ladungssensor und der Magnetflusssensor werden in unmittelbarer Nähe des Prüfobjektes platziert. Das primäre Magnetfeld wechselwirkt mit der magnetischen Suszeptibilität des Prüfobjektes, welches seinerseits eine Variation im primären Magnetfeld bewirkt, und so zu einem sekundären magnetischen Feld führt. Die Variationen im primären Magnetfeld werden im Anschluss mit einem Magnetflusssensor gemessen. Als Alternative beschreibt die WO 2012/092467 A2 ein Verfahren zur Bestimmung des Ladezustandes einer elektrochemischen Zelle. Die dazu verwendete Vorrichtung umfasst einen ersten Magneten zur Erzeugung eines ersten Magnetfeldes, welches dem ersten Magneten zugeordnet werden kann, und wenigstens einen Magnetfeldsensor, der eine Magnetfeldkomponente misst, die senkrecht zur Richtung des ersten Magnetfeldes ist. Der erste Magnet und wenigstens ein Magnetfeldsensor werden in der Nähe des Prüfobjektes angeordnet, so dass das erste Magnetfeld die elektrochemische Zelle durchdringt. Der Magnetfeldsensor erzeugt ein Signal, und der Ladungszustand der elektrochemischen Zelle wird anhand des gemessenen Signals bestimmt.

Auch aus WO 2009/146547 A ist eine Testvorrichtung für Batterien bekannt, bei der zur Messung der Suszeptibilität eines Prüfobjektes ein Elektromagnet oder ein Permanentmagnet zur Erzeugung eines äußeren Magnetfeldes verwendet werden. Weiterhin ist vorgesehen, dass ein Batteriestrom selbst das Magnetfeld zur Messung der Suszeptibilität erzeugt. Ferner ist ein Stromsensor vorgesehen, um Fluktuationen in der Strommessung mit Fluktuationen eines detektierten Magnetfeldes zu korrelieren.

Seit langem ist die Magnettomographie als nicht invasive Methode zur Messung, Analyse und 3-dimensionale Darstellung von Stromdichteverteilungen in Brennstoffzellen bekannt, beispielsweise aus DE 10 2006 035 741 A1. Die Methode basiert auf der Messung des magnetischen Feldes, welches durch den innerhalb der Zelle fließenden Stromfluss generiert wird, mittels eines 3-dimensionalen Magnetfeldsensors. Um die magnetischen Flussdaten an verschiedenen Stellen des Brennstoffzellenstapels ermitteln zu können, wurde ein 4-Achsen Positionsgerät entwickelt. Zusammen mit den Positionsdaten des Sensors und den gemessenen magnetischen Daten kann anschließend der Stromfluss innerhalb des Brennstoffzellenstapels über eine Rekonstruktion berechnet werden.

Bei der magnetischen Streuflussmessung, die ebenfalls zur Bestimmung der StromdichteVerteilung in einer elektrochemischen Zelle, insbesondere in einer Brennstoffzelle, eingesetzt werden kann, zeigt sich die Rückrechnung von gemessenen Feldstärken basierend auf der flächigen Vermessung einer Magnetfeldkomponente zur Identifizierung der erzeugenden Stromverteilung in dem Körper regelmäßig als sehr aufwändig (DE 10 2007 044 257 A1).

Bislang ist jedoch noch keine Rekonstruktion der tatsächlichen Stromdichteverteilung an Batterien möglich, da diese eine Variation der magnetischen Suszeptibilitäten aufweisen, die bislang bei der Rekonstruktion noch nicht berücksichtigt werden konnte.

Somit ist derzeit keine örtlich aufgelöste Charakterisierung von Batterien bezüglich des Ladezustands und/oder von Alterungseffekten ohne einen invasiven Eingriff oder einer Änderung des Messobjektes bekannt.

Aus [1] ist allerdings bekannt, wie sich die experimentellen Lade- und Entladezustände für eine $Li_xCoO_2$-Elektrode mit $0,5 < x < 1,0$ modellieren lassen. Es hat sich dabei herausgestellt, dass sich die magnetische Permeabilität in Abhängigkeit vom Li-Gehalt (x) sehr stark ändert. So wurde für einen Li-Gehalt von nahezu 1 (0,985) eine relative Permeabilität von $0,44*10^{-4}$ ermittelt, während für einen Li-Gehalt von 0,51 eine relative Permeabilität von $4,11*10^{-4}$ ermittelt wurde, das entspricht fast einem Faktor 10 in der Permeabilität.

In [2] wurden ebenfalls bereits die magnetischen und strukturellen Eigenschaften von $Li_2CoO_2$ als Material für wiederaufladbare Batterien untersucht. Es wurde festgestellt, dass sich das elektrochemische Verhalten während des Ladens und des Entladens deutlich unterscheidet.

Aufgabe und Lösung

Die Aufgabe der Erfindung ist es, ein berührungsloses und zerstörungsfreies Verfahren bereitzustellen, mit dem zumindest qualitativ der Ladezustand einer Batterie während des Betriebs sowie Änderungen von Materialeigenschaften auf Grund geänderter Ladezustände oder Alterung ohne Aufprägung eines äußeren Magnetfeldes detektiert werden können.

Die Aufgabe der Erfindung wird gelöst durch ein Verfahren mit den Merkmalen des unabhängigen Anspruchs 1 sowie durch eine Vorrichtung zur Durchführung des vorgenannten Verfahrens mit den Merkmalen gemäß des unabhängigen Anspruchs 12. Vorteilhafte Ausgestaltungen des Verfahrens und der Vorrichtung sind den jeweils darauf rückbezogenen Unteransprüchen zu entnehmen.

Gegenstand der Erfindung

Die Aufgabe der Erfindung ist es, ein berührungsloses und zerstörungsfreies Verfahren bereitzustellen, mit dem zumindest qualitativ oder bei Kenntnis von Referenzen auch quantitativ der Ladezustand einer Batterie während des Betriebs sowie Änderungen von Materialeigenschaften auf Grund geänderter Ladezustände, oder Alterung ohne Aufprägung eines äußeren Magnetfeldes, detektiert werden können.

Die Erfindung stellt ein Verfahren und eine Vorrichtung bereit, mit deren Hilfe über die Messung magnetischer Eigenschaften eines Prüfobjektes, zumindest qualitativ oder bei Kenntnis von entsprechenden Referenzen auch quantitativ der Betriebszustand des Prüfobjektes sowie Änderungen von Materialeigenschaften auf Grund geänderter Ladezustände, oder Alterung ohne Aufprägung eines äußeren Magnetfeldes, detektiert werden können. Dazu wird vorteilhaft die Messung der magnetischen Flussdichte B während eines inneren Stromflusses durch das Prüfobjekt ohne das Anlegen eines äußeren Magnetfeldes mit Hilfe wenigstens eines Magnetfeldsensors vorgeschlagen. Aus den Ergebnissen lassen sich Rückschlüsse auf den relativen und absoluten Ladezustand des Prüfobjektes, die Verfolgung von Alterungsprozessen des Prüfobjektes sowie relative Aussagen zur Qualität des Prüfobjektes machen, beispielsweise durch das Erkennen von Defekten oder Anomalien.

Hierzu wird ausgenutzt, dass die magnetische Flussdichte B proportional zum Strom I als auch der magnetischen Feldkonstante $\mu_0$ ist. Ein Stromleiter der infinitesimalen Länge dl am Ort r', der von einem Strom I durchflossen wird, erzeugt am Ort r die magnetische Flussdichte dB (unter Verwendung des Kreuzprodukts):

$$\mathrm{d}\boldsymbol{B}(\boldsymbol{r}) = \frac{\mu_0}{4\pi} I\,\mathrm{d}\boldsymbol{l} \times \frac{\boldsymbol{r} - \boldsymbol{r}'}{|\boldsymbol{r} - \boldsymbol{r}'|^3}$$

Dabei ist zu berücksichtigen, dass die magnetische Flussdichte B über die Permeabilität μ mit der magnetischen Feldstärke H in Beziehung steht. Anders ausgedrückt heißt das Verhältnis der magnetischen Flussdichte B zur magnetischen Feldstärke H Permeabilität μ.

$$\vec{B} = \mu \vec{H}$$

Die magnetische Feldkonstante $\mu_0$ ist eine physikalische Konstante und gibt die magnetische Permeabilität des Vakuums an. Auch dem Vakuum ist eine Permeabilität zugewiesen, da sich auch dort Magnetfelder einstellen oder elektromagnetische Felder ausbreiten können. Die Permeabilitätszahl $\mu_r$, auch als relative Permeabilität bezeichnet, ist das Verhältnis von μ zur magnetischen Feldkonstante $\mu_0$.

$$\mu_r = \frac{\mu}{\mu_0}$$

Für das Vakuum ergibt sich folglich die relative Permeabilitätszahl von 1. Die dimensionslose Größe $\mu_r$ hängt mit der magnetischen Suszeptibilität χ zusammen über folgende Beziehung:

$$\mu_r = 1 + \chi$$

Die Magnetisierung *M* ist eine physikalische Größe zur Charakterisierung des magnetischen Zustands eines Materials, und berechnet sich über das magnetische Moment $\mu_{pro}$ Volumen V:

$$\vec{M} = \frac{d\vec{\mu}}{dV}$$

Außerdem steht die Magnetisierung mit der magnetischen Flussdichte B und der magnetischen Feldstärke *H* über folgende Gleichung im Zusammenhang:

$$\vec{B} = \mu_0 \left( \vec{H} + \vec{M} \right)$$
$$= \mu \vec{H}$$

Hierbei ist $\mu_0$ die magnetische Feldkonstante bzw. μ die Permeabilität. Ist μ kleiner als $\mu_0$, so liegt eine negative Magnetisierung vor.

Zur Erläuterung: Je nach Richtung und Stärke der Magnetisierung M unterscheidet man drei Arten von Magnetismus:

| Bezeichnung | Suszeptibilität | Permeabilität |
|---|---|---|
| Diamagnetismus | $\chi < 0$, $|\chi| \ll 1$ | $\mu < 1$ |
| Paramagnetismus | $\chi > 0$, $|\chi| \ll 1$ | $\mu > 1$ |
| Ferromagnetismus | $\chi > 0$, $|\chi| \gg 1$ | $\mu \gg 1$ |

Ein (externer) Magnetfeldsensor misst in der Regel immer das B-Feld, und somit nie nur den Stromanteil allein, sondern auch die magnetischen Eigenschaften der in seiner Umgebung befindlichen Materialien. Die magnetischen Eigenschaften der in seiner Umgebung befindlichen Materialien wirken dabei auf Grund seines Einzugbereiches auf ihn als eine gemittelte Größe.

Zu den typischen Sensorarten, mit denen magnetische Eigenschaften ermittelt werden können, gehören beispielsweise SQUIDs, Hall-Sensoren, Fluxgate-Sensoren sowie AMR-Sensoren.

Beim SQUID basiert der Messeffekt auf einem Quanteneffekt. Als Supraleiter werden gewöhnlich Temperaturen kleiner als 77 K und eine thermische Isolierung benötigt. Die Regelungselektronik ist beliebig aufwändig und es kann immer nur eine Magnetfeldkomponente detektiert werden. Zudem sind lediglich Relativ- aber keine Absolutmessungen möglich. Dafür weist der Sensor aber eine besonders hohe Empfindlichkeit für relative Feldänderungen bis in den fT-Bereich auf. Als Antwortgröße wird ein Spannungswert erhalten.

Beim Hall-Sensor basiert der Messeffekt auf der Ablenkung bewegter Ladungsträger. Als Antwortgröße wird ebenfalls ein Spannungswert erhalten, der aber elektrisch nicht belastet werden darf. Die Auflösung reicht bis zu einigen 100 nT. In der Standardbauform mit Sensorgrundflächen von nur einigen $mm^2$ sind sowohl eine als auch mehrere Magnetfeldkomponenten messbar. Der Messbereich und die Auflösung lassen sich in gewissen Grenzen über Material und Geometrie des Sensors einstellen. Nachteilig weist der Hall-Sensor aber Probleme mit Linearität auf und zeigt zudem eine Temperaturabhängigkeit. Die Empfindlichkeit steigt mit dem Messstrom, welcher jedoch aufgrund des Eigenmagnetfelds selbst Einfluss auf die Messgröße nehmen kann.

Beim Fluxgate-Sensor bewirkt die Polaritäts- bzw. richtungsabhängige Sättigungsenergie eines weichmagnetischen Materials den Messeffekt, der zur vektoriellen Bestimmung des Magnetfeldes bzw. für lokale Materialfehler eingesetzt werden kann. Als Antwortgröße wird ein Spannungswert erhalten. Auch hier lassen sich Bereich und Auflösung durch die Art und Menge (Volumen) des weichmagnetischen Materials einstellen. Die Auflösung reicht von 0,1 nT bis zu einem mT, wobei aber entsprechend empfindliche Sensoren eine relativ große Bauform aufweisen. Es sind bereits 1-, 2- und 3-Komponentenmessung im selben Messvolumen möglich, wobei mehr Komponenten regelmäßig ein größeres Bauvolumen benötigen. Der Fluxgate-Sensor, auch als Förster-Sonde bezeichnet, zeigt ebenfalls eine Temperaturabhängigkeit.

Beim AMR-Sensor (AMR = anisotroper magnetoresistiver Effekt) ergibt sich der Messeffekt aus der Veränderung der elektronischen Bandstruktur eines Materials mit einem Effekt auf das Leitungsband. Die Antwortgröße ist ebenfalls ein Spannungswert. Der AMR-Sensor ist temperaturabhängig und erfasst nur eine Magnetfeldkomponente. Die Sensorgrundfläche liegt im Bereich von einigen 100 $\mu m^2$, überstreicht jedoch bei hoher Linearität einen großen Dynamikbereich >> 1:10000 bei einer Empfindlichkeit < 10 mT. Die Empfindlichkeit ist vom Sensormaterial abhängig. Da der Sensor polarisiert werden muss, ergeben sich teilweise Probleme bei der Sättigung des Sensors.

Bei der Untersuchung einer Batterie als Prüfobjekt, insbesondere einer Li-Ionen Batterie, hängt die Änderung der magnetischen Eigenschaften von vielen Faktoren ab. Die folgende Tabelle 1 gibt Aufschluss darüber, welche Beiträge die einzelnen Komponenten einer Li-Ionen Batterie bei einer magnetischen Untersuchung beitragen können.

| Funktion | | Material | Magnetische Eigenschaft | Magnetische Suszeptibilitäten (SI) |
|---|---|---|---|---|
| Hülle | | Polymer, elektrisch | schwach paramagnetisch | PE: $4,4*10^{-6}$ |
| Wiederholeinheit (repetitiv oder alternierende Reihenfolge) | Stromkollektor | Aluminium | schwach paramagnetisch | $2,1*10^{-5}$ |
| | Kathode | $LiFePO_4$, $LiCoO_2$, Li$(Mn,Ni,Co)O_X$ | diamagnetisch bis paramagnetisch, antiferromagnetisch | $LiFePO_4$: 4,5 - 4,7$\mu_B$ $LiMnO_4$: 3,9 - 4,4 $\mu_B$ $LiNiO_2$: 0,2 - 1,7 $\mu_B$ |
| | Separator mit Elektrolyt | $LiPF_6$, Li-Ionen Batterie $F_4$, ionische Flüssigkeiten, Polymer | diamagnetisch | k. a. |
| | Anode | Kohlenstoff + Li | diamagnetisch und schwach paramagnetisch | $-(4,5..8,5)*10^{-5}$ bis $1,4*10^{-5}$ |
| | Stromkollektor | Kupfer | diamagnetisch | $-9,6*10^{-6}$ |

(fortgesetzt)

| Funktion | | Material | Magnetische Eigenschaft | Magnetische Suszeptibilitäten (SI) |
|---|---|---|---|---|
| Hülle | | Polymer, elektrisch isolierend | diamagnetisch | PE: $4{,}4*10^{-6}$ |

Aus der vorangegangenen Tabelle 1 kann daher in erster Näherung geschlossen werden, dass Änderungen der magnetischen Eigenschaften bei den derzeitig üblichen Materialien für Li-Ionen Batterien hauptsächlich auf Veränderungen innerhalb der Kathode zurückzuführen sind.

Der prinzipielle Zusammenhang zwischen der an der Batterie anliegenden Spannung und dem Lithiumgehalt in der Kathode ist bereits in [2] beschrieben. Daraus lässt sich schließen: je höher die Spannung, die eine Li-Ionen Batterie aufweist, umso niedriger ist der LithiumGehalt in der Kathode.

Es wurde in weiteren Experimenten zudem festgestellt, dass die Leerlaufspannung $V_{OCV}$ (OCV = offene Zellspannung) einerseits vom Li-Gehalt in der Kathode abhängt und andererseits auch von dem spezifischen Ladezustand (SOC= state of charge). Über diese beiden Korrelationen kann dann weiter der Schluss gezogen werden, dass der Li-Gehalt einer Kathode eine Aussage zum Ladezustand der Batterie zulässt.

Die vorgenannten Effekte lassen sich am Beispiel einer Lithium-Ionen Batterie wie folgt zusammenfassen. Unterschiedliche Ladungszustände in der Batterie führen aufgrund des Ein- und Ausbaus von Lithium-Ionen zu unterschiedlichen Lithiumgehalten in der Kathode. Das Kathodenmaterial weist gegenüber den sonstigen verwendeten Materialien eine besonders hohe Variation der Suszeptibilität auf. Das bedeutet, dass sich aufgrund geänderter Ladungszustände die magnetischen Eigenschaften der Batterie, insbesondere der Kathode ändern. Damit ändert sich aber auch das jeweilige externe Magnetfeld bei vergleichbarem Stromfluss der Batterie. Änderungen der Stromdichteverteilung bei unterschiedlichen Ladezuständen sind nicht auszuschließen, sie spielen jedoch gemessen an Änderungen der magnetischen Eigenschaften eine untergeordnete Rolle. Insofern kann über die Messung der magnetischen Flussdichte an einer oder mehreren Stellen, zeitgleich oder zeitlich versetzt, eine qualitative Aussage über den Lithiumgehalt in der Batterie vorgenommen werden. Bei Kenntnis einer Referenz über $V_{OCV}$ ist dies auch quantitativ möglich. Damit lassen sich auf einfache Weise beispielsweise relative Veränderungen im Ladezustand einer Batterie erkennen oder auch Alterungserscheinungen dokumentieren. Ferner ist so eine einfache Defektanalyse und somit auch eine Qualitätskontrolle möglich. Vergleicht man die aktuell gemessenen Daten mit bereits hinterlegten Kennfeldern, die je nach Batterietyp oder -bauart differieren können, oder auch Referenzmessungen zum gleichen Batterietyp oder gleicher Bauart, so können auch detaillierte Aussagen beispielsweise zum Wert des aktuellen Ladungszustands gemacht werden.

Zur qualitativen Ermittlung der magnetischen Eigenschaften, und dabei insbesondere der magnetischen Suszeptibilität eines Prüfobjekts, beispielsweise einer Li-Ionen Batterie, wird erfindungsgemäß der folgende Messaufbau vorgeschlagen.

Die erfindungsgemäße Messapparatur besteht aus den Komponenten Magnetfeld-Sensorsystem, bestehend aus wenigstens einem Magnetfeldsensor, sowie elektrisches Sensorsystem, bestehend aus wenigstens einem Stromsensor. Zudem weist die Messapparatur eine Datenerfassungs- bzw. auswerteinheit auf. Vorteilhaft ist ein Mittel zur Aufnahme und Fixierung eines Prüfobjektes sowie des Magnetfeldsensors vorhanden, so dass während der Messungen eine unerwünschte Relativbewegung zwischen Prüfobjekt und Magnetfeldsensor ausgeschlossen werden kann.

Im einfachsten Fall liegt nur ein Magnetfeldsensor vor, der zumindest eine Komponente der magnetischen Flussdichte B erfassen kann. Das Ergebnis, ein Vektor oder eine Vektorkomponente des B-Feldes, kann sowohl analoger, z. B. als Spannungssignal, als auch digitaler Natur sein. Die Ergebnisse (Daten, Outputsignale) können kontinuierlich oder auf Anforderung bereitgestellt werden. Bei Messungen mit einem solchen Magnetfeldsensor muss sichergestellt werden, dass die Ausrichtung des Magnetfeldsensors in Bezug auf die stromführenden Teile des Prüfobjektes, welche ein magnetisches Feld erzeugen, bei vergleichenden Messungen jeweils identisch ausgerichtet ist. Dies ist insbesondere bei zeitlich versetzten Messungen oder auch örtlich versetzten Messungen zu beachten.

In einer vorteilhaften Ausgestaltung der Erfindung werden Magnetfeldsensoren eingesetzt, die alle Komponenten der magnetischen Flussdichte und damit die x-, y- und z-Komponente des B-Feldes (Raumrichtung) erfassen können. Dies bietet insbesondere Vorteile, wenn örtlich versetzte Messungen durchgeführt werden. Zudem ist durch diese Sensorart auch das Gesamtmagnetfeld B ermittelbar, welches erweiterte Anwendungsmöglichkeiten zulässt.

In einer weiteren vorteilhaften Ausgestaltung der Erfindung werden mehrere Magnetfeldsensoren (Sensor-Array) eingesetzt, um so vorteilhaft die magnetische Flussdichte B zeitgleich an mehreren Stellen des Prüfobjektes aufnehmen zu können. Dies kann vorteilhaft sein, um die eigentliche Messzeit bei örtlich versetzten Messungen zu reduzieren. Somit wird auch der mögliche Einfluss von zeitlichen Variationen des Prüfobjektes minimiert.

Das elektrische Sensorsystem umfasst ferner wenigstens einen Stromsensor, dessen Ergebnis ebenfalls analoger, z. B. als Spannungssignal, oder aber auch digitaler Natur sein kann. Auch die elektrischen Ergebnisse (Daten, Outputsignale) können kontinuierlich oder auf Anforderung bereitgestellt werden.

Die von dem Magnetfeld-Sensorsystem und dem elektrisches Sensorsystem ermittelten Daten werden vorteilhaft in einem Datenspeichersystem erfasst. Idealerweise erfolgt die Datenerfassung dabei zeitsynchron. Vorteilhaft kann das Datenspeichersystem darüber hinaus zusätzlich die Daten der optionalen Datenquellen aufzeichnen, wie beispielsweise die Temperatur oder der exakte Messzeitpunkt.

Vorteilhaft verfügt die Messapparatur zusätzlich über einen Signalgeber zur Synchronisierung und Steuerung der Mess- und Positioniersysteme. Weiterhin bietet eine Schnittstelle zur Weitergabe der aufgezeichneten Daten an ein Datenverarbeitungssystem einen weiteren Vorteil.

In einer besonders einfachen Ausführung der Erfindung ist der oder sind die Magnetfeldsensoren fest mit dem Prüfobjekt verbunden, so dass eine unerwünschte Relativbewegung zwischen diesen beiden Bauteilen während der Messung vermieden werden kann.

Sofern keine fixierte Verbindung zwischen Prüfobjekt und Magnetfeldsensor vorhanden ist, kann gegebenenfalls über ein Mittel zur Aufnahme und Fixierung eines Prüfobjektes sowie wenigstens eines Magnetfeldsensors sichergestellt werden, dass während der Messungen eine unerwünschte Relativbewegung zwischen Prüfobjekt und einem oder mehreren Magnetfeldsensoren ausgeschlossen werden kann. Das Mittel ermöglicht in der Regel eine Fixierung derart, dass der Magnetfeldsensor im Bezug auf das Prüfobjekt so nah angeordnet ist, dass der eingesetzte Magnetfeldsensor das vom Prüfobjekt erzeugte Magnetfeld zu messen vermag. Dabei haben sich Abstände zwischen dem während der Messung Strom durchflossenen Teil des Prüfobjektes und dem Magnetfeldsensor zwischen 0,1 und 200 mm, insbesondere zwischen 2 und 10 mm, als ausreichend herausgestellt.

Die nachfolgend aufgeführten weiteren Komponenten können vorteilhaft einzeln oder auch in Kombination mit dem vorgenannten Messaufbau eingesetzt werden.

Als weitere Optionen für das Magnetfeld-Sensorsystem bieten sich beispielsweise an: Ein elektrisches oder digitales Filtersystem zum Minimieren von Störeinflüssen, ein System zur Konvertierung des Sensorsignals, z. B. von analog zu digital oder Spannung zu Strom und/oder ein System zur Erfassung der Betriebsparameter des Magnetfeldsensors und/oder der Temperatur des Prüfobjektes zur Korrekturmöglichkeit der Messergebnisse.

Ferner kann ein optionales Positioniersystem für einen oder mehrere Magnetfeldsensoren des Magnetfeldsorsystems für den Fall einer Nicht-Fixierung des oder der Magnetfeldsensoren mit dem Prüfobjekt vorgesehen werden. Die Ergebnisse (Daten) können wiederum kontinuierlich oder auf Anforderung bereitgestellt werden. Die Positionsbestimmung besteht aus der Angabe aller 3 Raumrichtungen entweder als Absolutposition des Magnetfeld-Sensors im Messraum, als Absolutposition des Prüfobjekts oder aber als Relativposition des Magnetfeld-Sensors zu einer vorher festgelegten Referenzposition bezüglich des Prüfobjekts.

Als weitere Optionen für das elektrische Sensorsystem bieten sich beispielsweise an: Ein elektrisches oder digitales Filtersystem zum Minimieren von Störeinflüssen, ein System zur Konvertierung des Sensorsignals, z. B. von analog zu digital oder Spannung zu Strom, ein System zur Erfassung der Betriebsparameter des Stromsensors, z. B. der Temperatur, zur Korrekturmöglichkeit der Messergebnisse und/oder ein System zur Erfassung der Spannung am oder im Prüfobjekt.

Die erfindungsgemäße Messapparatur weist zudem ein Stromstimulanzsystem auf. Das Stromstimulanzsystem umfasst im einfachsten Fall einen steuerbaren elektrischen Schalter zum Einstellen verschiedener elektrischer Betriebszustände. Eine komplexere Option wäre beispielsweise ein steuerbares Mehrquadranten-Netzteil, welches als Stromquelle oder-senke für das Prüfobjekt dient.

Das erfindungsgemäße Verfahren stellt eine Methode bereit, mit dessen Hilfe nur über die Messung des magnetischen Felds, welches das Prüfobjekt in Form einer Batterie bei einem Stromfluss selbst erzeugt, zumindest qualitativ der Ladungszustand des Prüfobjektes während eines inneren Stromflusses sowie Änderungen von Materialeigenschaften auf Grund geänderter Ladezustände oder Alterung ohne Aufprägung eines äußeren Magnetfeldes detektiert werden können.

Somit kann mit Hilfe der Messung des magnetischen Feldes, welches die Batterie während eines Lade- bzw. Entladevorgangs selbst erzeugt, beispielsweise eine qualitative Beurteilung komparativ zu anderen Zellen gleichen Typs oder chronologisch beispielsweise zur Kontrolle des Ladungszustands, der Verfolgung von Alterungsvorgängen oder sonstigen Diagnosezwecken erfolgen. Am Beispiel einer Li-Ionen Batterie konnte gezeigt werden, dass diese Veränderungen unmittelbar mit dem Li-Gehalt der Kathode korrelieren, und dieser aufgrund der hohen Variation der magnetischen Suszeptibilität im Rahmen der magnetischen Messung erfasst werden kann.

Die erfindungsgemäße Messung des magnetischen Feldes sollte dabei die folgenden Anforderungen erfüllen.

Die Empfindlichkeit des Magnetfeld-Sensorsystems sollte im Idealfall so hoch wie möglich sein. Die Empfindlichkeit des Sensors hängt jedoch hauptsächlich von dem Messabstand zum Prüfobjekt und von den zu erwartenden Änderungen der Magnetflussdichte ab.

Des Weiteren bestimmt die Empfindlichkeit aufgrund der $1/r^2$-Abhängigkeit der Magnetflussdichte auch den, effektiven Einzugsbereich'. Unter dem, effektiven Einzugsbereich' im Sinne der Erfindung ist gemeint, dass ein magnetisches Feld, welches in einer größeren Distanz induziert wird, aufgrund dessen Abschwächung und der begrenzten Empfindlichkeit nicht mehr erfasst werden kann. Typische Werte richten sich hauptsächlich nach dem verwendeten Magnetfeldsensortyp und können im Bereich zu einigen nT bis zu einigen fT reichen. Eine zu niedrige Empfindlichkeit erfordert dagegen hohe Ströme, um das Defizit zu kompensieren. Des Weiteren kann die Empfindlichkeit auch durch die Messumgebung limitiert werden, wenn nicht zu beseitigende oder kompensierbare magnetische Störfelder vorhanden sind.

Der Messbereich des Magnetfeld-Sensorsystems richtet sich hauptsächlich nach der Messumgebung, der maximalen Stromdichte, des Abstandes und der magnetischen Permeabilität der Prüfobjektkomponenten. Wird beispielsweise in einem magnetisch nicht abgeschirmten Umfeld gemessen, so muss der Magnetfeld-Sensor mindestens die (lokale) Erdmagnetfeldstärke ($\sim 50\ \mu T$) inklusive des induzierten Magnetfeldes erfassen können.

Die Auflösung des Magnetfeld-Sensorsystems richtet sich nach den vorhandenen Materialien des Prüfobjekts. An diesen Änderungsbereich muss das System angepasst sein. Es sollte daher im besten Fall mindestens eine um den effektiven Faktor 10 bessere Auflösung besitzen, damit auch eine Abstufung mit 10 Schritten erkennbar ist. Das bedeutet, dass bei einer zu erwartenden Änderung der magnetischen Permeabilität in der Größenordnung von $10^{-4}$ das System eine Auflösung von mindestens $10^{-5}$ für diesen Parameter aufweisen sollte.

Die Auflösung des elektrischen Sensorsystems sollte idealer weise gleich oder besser als die des Magnetfeldmesssystems sein, zumindest in Bezug auf den Strom. Die optionalen Werte stellen in der Regel keine direkten Bezugswerte für das Messverfahren dar und können somit auch nur schlechter aufgelöst werden.

Der Messbereich des elektrischen Sensorsystems sollte mindestens das zu erwartende oder einzustellende maximale Stromintervall (min/max) abdecken und dies mit ausreichender Genauigkeit abbilden können. Beispielsweise sollte für die Überprüfung einer Batterie mit einer maximalen Belastbarkeit von 100 A der Messbereich für die Stromquelle- bzw. senke mindestes 100 A umfassen und die Auflösung wenigstens 1 mA betragen.

Sofern ein Positioniersystem verwendet wird, sollte dies eine besonders gute Wiederholgenauigkeit aufweisen, das heißt so gut wie möglich sein. Eine gute Wiederholgenauigkeit liegt beispielsweise bei einigen 100 $\mu m$ und besser. Die Wiederholgenauigkeit bestimmt maßgeblich die Vergleichbarkeit der Messergebnisse. Ist diese zu schlecht, kann es zu Messabweichungen kommen, welche im schlechtesten Fall in der Größenordnung des jeweiligen Messwerts liegen.

Die Auflösung bzw. die Schrittweite des eingesetzten Positioniersystems ist hauptsächlich abhängig vom jeweiligen Abstand des Magnetfeldsensors zur Magnetfeldquelle und der gewünschten Abbildungsgenauigkeit. Höhere Werte des Verhältnisses Abstand zu Auflösung als 100 sind selten sinnvoll. Bei einem Abstand von bis zu 5 mm ist regelmäßig eine Schrittweite von 500 $\mu m$ ausreichend.

Das verwendete Datenspeichersystem sollte in der Lage sein, alle anfallenden Messgrößen idealweise zeitsynchron zu erfassen. Die Daten sollten mit der jeweiligen Auflösung abgespeichert werden und vorteilhaft einen Zeitstempel aufweisen.

Die erfindungsgemäße Messung (Messablauf) erfolgt prinzipiell wie nachfolgend am Beispiel einer Li-Ionen Batterie beschrieben. Die zu überprüfende Batterie wird dazu in der Messapparatur angeordnet, fixiert und elektrisch kontaktiert.

Ein typischer Messablauf für einen Messpunkt besteht dabei aus den nachfolgend aufgeführten Schritten und wird im Folgenden als "typischer Messablauf für einen Messpunkt" bezeichnet.

Wenigstens ein Magnetfeldsensor wird in der Nähe der Li-Ionen Batterie positioniert. Die Batterie wird in einen ersten Zustand i = 1 versetzt, der einem Strom $I_1$ entspricht. Die Einstellung des Stroms kann beispielsweise durch Anlegen einer Last mit einem definierten Widerstand (Verbraucher) (Entladung) oder auch einer externen Stromquelle (Ladung) erfolgen. Es wird je nach eingesetztem Magnetfeldsensor wenigstens ein Vektor oder eine Vektorkomponente des magnetischen Feldes $B_1$ in Abhängigkeit vom eingestellten Strom $I_1$ gemessen, welches durch den Stromfluss innerhalb der Batterie generiert wird.

Die Batterie wird anschließend in einen zweiten Zustand i = 2 versetzt, der einem Strom $I_2$ entspricht. Der Unterschied der Ströme $I_1$ und $I_2$ sollte dabei vorteilhaft ausreichend groß sein, um im Falle einer Nichtlinearität diese auch zu erkennen. Ein Fachmann könnte dazu gegebenenfalls einige Voruntersuchungen (siehe Referenzmessungen im speziellen Beschreibungsteil) oder Abschätzungen aufgrund bekannter Literaturdaten vornehmen. Es wird erneut wenigstens ein Vektor bzw. eine Vektorkomponente des magnetischen Feldes $B_2$ in Abhängigkeit vom eingestellten Strom $I_2$ gemessen.

Gegebenenfalls können je nach Anforderung weitere Zustände i = 3, 4,... eingestellt und analog wir vorbeschrieben zu jedem Zustand die magnetische Feldstärke Bi gemessen werden.

Die einzustellenden Zustände i unterscheiden sich dabei jeweils im Gesamtstrom I von einander und werden zeitlich ohne größere Abstände erfasst. Im Rahmen dieser Erfindung bedeutet zeitlich ohne größere Abstände, dass die Gesamtmesszeit aller Zustände, d. h. inklusive der Messpausen zwischen den Zuständen, nicht mehr als 1 Minute beträgt. Die Messung des B-Feldes benötigt dabei selbst eine nur kurze Messzeit $t_{mess}$, beispielsweise im Bereich von 1 ms bis zu 1 s. Das Integral von I und $t_{mess}$ sollte weniger als 1 % der Gesamtkapazität der Batterie betragen, vorteilhaft nur 0,1 %. Dadurch kann sichergestellt werden, dass durch das Einstellen der Zustände i und dem dadurch fließenden Strom die Änderung im Ladezustand der Batterie während der Messungen vernachlässigt werden kann.

Der geringe zeitliche Abstand zwischen den Messungen verhindert dabei regelmäßig den temporalen Einfluss auf das Magnetfeld aufgrund externer Störungen, z. B. von Erdmagnetfeldänderungen, Änderungen des Ladezustandes, Änderungen der thermischen Eigenschaften des Prüfobjektes oder auch Änderung des Prüfobjektes selbst in Form von geometrischen oder elektrochemischen Gleichgewichtseinstellungen.

Nach der Messung der Messwertpaare aus Gesamtstrom $I_i$ und magnetischem Feld $B_i$ für einen jeden Zustand i erfolgt die qualitative Auswertung der ermittelten Daten wie folgt.

Zur besseren Vergleichbarkeit wird für jeden Zustand i zunächst der Quotient $Q_i$ aus Magnetfeld bzw. Magnetfeldkomponente $B_i$ zu Gesamtstrom $I_i$ gebildet. Unter der Annahme, dass während der zeitlich zusammenhängenden Messwerterfassung das Prüfobjekt selbst kaum Änderungen erfahren hat, kann angenommen werden, dass die Stromdichteverteilung im Messobjekt selbst nahezu gleich geblieben ist. Somit sollte der Quotient $Q_i$ proportional zur magnetischen Suszeptibilität $\chi$ sein.

Vorteilhaft wird neben der Quotientenbildung $Q_i$ die Steigung zwischen den Messwertpaaren für einen Messpunkt zur Charakterisierung herangezogen. Dazu wird die Steigung aus jeweils zwei Wertepaaren ermittelt zu:

$$m_{i,j} = \Delta(Q_i, Q_j) / \Delta(I_i, I_j) \text{ mit } i \neq j \text{ und } i, j = \text{einzelne Stromzustände.}$$

Durch den Vergleich der Steigungen kann über den Grad der Übereinstimmung auf den Ladezustand der Batterie geschlossen werden.

Es ist anzumerken, dass in einer magnetisch stabilen Umgebung (magnetisch vollständig abgeschirmte Umgebung und Ausschluss aller magnetischer Störungen, die nicht vom Prüfobjekt selbst stammen, z. B. MU-Metall-Käfig oder magnetisch kompensierte Kammer) der Vergleich mit einer zweiten Stromstärke (zweiter Zustand) entfallen könnte. Hierbei würde dann nur ein Betriebszustand des Prüfobjekts, definiert durch den Gesamtstrom, ermittelt. In der Realität wird man jedoch um regelmäßig magnetische Hintergrundeffekte auszuschließen, mindestens zwei unterschiedliche Stromzustände einstellen und aus der Differenz der Messungen auf den Betriebszustand des Prüfobjekts schließen.

Nachfolgend werden zwei spezielle Messungen und Auswertungen vorgestellt, die jedoch nicht abschließend zu werten sind, und lediglich einen Eindruck geben sollen, bei welchen Fragestellungen die Erfindung vorteilhaft angewendet werden kann.

A. Es soll der relative Lade- bzw. Entladungszustand (gemittelte Suszeptibilität) einer Batterie verfolgt, bzw. überwacht werden.

Hierbei wird der relative Ladungszustand der Batterie qualitativ mit Hilfe der Messungen an wenigstens zwei Messpunkten gemäß dem typischen Messablauf für einen Messpunkt vorgenommen werden. Die Messpunkte unterscheiden sich dabei nicht in ihrer örtlichen Lage, sondern werden zeitversetzt, d. h. zu verschiedenen Zeiten aufgenommen. Es wird angenommen, dass der für die Messung ausgewählte Ort ein charakteristisches Maß für die gemittelte Suszeptibilität der Batterie darstellt. Der Ort wurde beispielsweise über Vorversuche festgelegt, wie sie im Kapitel spezieller Beschreibungsteil ausgeführt sind. Die Zeitintervalle zwischen den Messungen können dabei in der Größenordnung von einigen Minuten bis zu einigen Stunden liegen. Für eine diesbezügliche Auswertung sind bereits zwei Zustände pro Messpunkt ausreichend. Für alle Messpunkte werden vorzugsweise gleiche Zustände gewählt, d. h. gleiche Ströme $I_1$ und $I_2$ gewählt.

Für jeden Zustand i wird zunächst der Quotient $Q_i$ aus Magnetfeld, bzw. Magnetfeldkomponente $B_i$ zu Gesamtstrom $I_i$ gebildet. Ferner werden daraus jeweils die Steigungen für jeden Messpunkt ermittelt über $m_{i,j} = \Delta(Q_i, Q_j) / \Delta(I_i, I_j)$ mit $i \neq j$, und i, j = einzelne Stromzustände. Verglichen werden nunmehr die Steigungen, die sich für die einzelnen zeitlich versetzten Messpunkte ermitteln lassen. Besitzen 2 Messpunkte eine vergleichbare Steigung m, so ist von einem nahezu unveränderten Ladungszustand auszugehen. Andernfalls erkennt man eine Änderung im Ladungszustand entsprechend der Änderung in den Steigungen.

Wird in einer vorteilhaften Ausführung des Verfahrens eine Referenzkurve zu Hilfe genommen, aus welcher hervorgeht, welche Steigung m welchem Ladungszustand zugeordnet werden kann, ist nicht nur eine Aussage zum relativen Ladungszustand zwischen den Messpunkten, sondern auch ein Rückschluss auf den jeweiligen absoluten Ladungszustand möglich. Die erwähnte Referenzkurve ist jedoch vom Batterietyp, vom verwendeten Elektrodenmaterial und der Bauform und auch der Messumgebung abhängig und muss daher mindestens einmal unter identischen Bedingungen erstellt werden.

Die Referenzkurve kann beispielsweise dadurch erstellt werden, dass ein kompletter Lade- bzw. Entladezyklus überwacht wird und die anfallenden Wertepaare hierzu abgelegt werden. Weiteres findet sich im Kapitel spezieller Beschreibungsteil.

B. Es soll der momentane Lade- bzw. Entladezustand einer Batterie ermittelt werden.

Hierbei wird der Ladezustand der Batterie qualitativ mit Hilfe der Messungen an wenigstens einem Messpunkt gemäß dem typischen Messablauf für einen Messpunkt vorgenommen, wobei aber zumindest drei unterschiedliche Zustände i eingestellt werden. Die Messungen erfolgen ortsfixiert.

Für den Fall, dass drei Zustände eingestellt werden, kann durch einen Vergleich der gebildeten Quotienten $Q_1, Q_2$ und $Q_3$ gegenüber der Messgrößen $I_1, I_2$ und $I_3$, die wiederum selbst direkt proportional zum Magnetfeld B sind, dann eine Aussage über die Linearität von $\mu$ getroffen werden, die inhärent auch eine Aussage zum Ladungszustand der Batterie zulässt. Würden für $Q_1$, $Q_2$ und $Q_3$ im Rahmen der Messgenauigkeit von beispielsweise 1 ‰ identische Werte erhalten werden, so würde das für $LiCoO_2$ als Kathodenmaterial auf eine Linearität von $\mu$ hinweisen, die auf einen Ladezustand nahe 0 % schließen lässt, da das Kathodenmaterial hierbei nahezu ideal para-/diamagnetische Eigenschaften aufweist [1].

Besonders geeignet neben der vorgenannten Quotientenmethode ist jedoch der Vergleich der Steigung m zwischen jeweils zwei Zuständen:

$$m_{i,j} = \Delta(Q_i,Q_j) / \Delta(I_i,I_j) \text{ mit } i \neq j \text{ und } i,j = \text{eingestellte Stromzustände.}$$

Für die drei Zustände ergeben sich hiermit drei mögliche Kombinationen: $m_{1,2}$, $m_{1,3}$ und $m_{2,2}$. Sind mindestens zwei Werte für die Steigung hiervon identisch, d. h. weisen denselben Wert innerhalb der Messgenauigkeit auf (z. B. 1 ‰), kann davon ausgegangen werden, dass $\mu$ unabhängig von I und somit auch B ist. Eine weitere Schlussfolgerung daraus ist, dass es sich für das Messobjekt um einen dia- oder paramagnetischen Zustand handeln muss. Konkret auf eine Li-Ionen Batterie mit $LiCoO_2$-Kathodenmaterial bedeutet dies auf einen Ladezustand nahe 0 % hin, wie auch bereits in [1] berichtet wird.

Unterscheiden sich dagegen mindestens zwei Werte für die Steigung signifikant, muss von einem nichtlinearen Verhalten von $\mu$ ausgegangen werden. Dies ist beispielsweise für ferro- und ferrimagnetische Materialien der Fall. Ein solches Verhalten ist für $LiCoO_2$ im Falle von ausgebautem Lithium, d. h. für einen Ladezustand wesentlich größer 0 % bekannt. Unter signifikant wird im Rahmen dieser Erfindung eine Abweichung um mehr als das doppelte der Messgenauigkeit, z. B. 1 ‰ verstanden. Die Messgenauigkeit bezieht sich dabei auf die Messungen des Gesamtstroms und der magnetischen Feldstärke und kann vorab von einem Fachmann abgeschätzt werden.

In einer besonders vorteilhaften Ausgestaltung der Erfindung könnte bei Kenntnis der Ausprägung der Nichtlinearität im Verhältnis zum Ladezustand, welcher sich je nach Li-Ionen Batterietyp und der jeweiligen Bauform unterscheiden kann und daher in der Regel zuerst einmal ermittelt werden muss, ein genauerer Rückschluss auf den aktuellen Ladezustand erfolgen. Auch hier kann es einem Fachmann überlassen werden, mit welcher Genauigkeit bezüglich der gesuchten Eigenschaften, z. B. dem Ladezustand, vorab spezifische Kennfelder aufzunehmen sind.

Als vorteilhafte Ausgestaltung können auch mehr als drei Messpunkte aufgenommen und ausgewertet werden. Sollten dabei alle Zustände 1 bis n (mit n ganzzahlig, n > 3) ebenfalls zeitlich ohne größere Abstände erfasst werden, ist wiederum eine Auswertung über die Nichtlinearität von $\mu$ möglich. Bei größeren zeitlichen Abständen zwischen den Messungen müsste andernfalls jedoch von einer Änderung des Ladezustands ausgegangen werden und dies bei der Auswertung entsprechend berücksichtigt werden.

Bei den Auswertungen gemäß der Punkte A. und B. ist ferner zu berücksichtigen, dass die Konstanz der Stromdichteverteilung nicht zwangsläufig gegeben ist, und somit Fehleinschätzungen auftreten können.

Den vorab aufgeführten Mess- und Auswertemethoden ist gemein, dass gegebenenfalls noch eine Korrektur bezüglich der Temperatur berücksichtigt werden muss, da $\mu$ im allgemeinen eine Funktion der Temperatur ist und somit dessen Einfluss mit berücksichtigt werden sollte (Curie-Weiss-Gesetz).

Ein bestmögliches Ergebnis kann beispielsweise dadurch erreicht werden, dass ein kombinierter Vergleich von Nichtlinearität (3-Punkt-Technik, Methode B.) und der gemittelten Suszeptibilität (Methode A.) in Verbindung mit einer Temperaturkorrektur durchgeführt wird.

In Ergänzung zu den bereits vorgenannten Auswertungen kann gegebenenfalls, sofern notwendig, eine Orts-Korrekturmaßnahme für die Vektorkomponenten des magnetischen Feldes erforderlich sein. Dies könnte insbesondere bei Nicht-Ortstreue der Magnetfeldkomponente und Darstellung dieser bei ortsveränderlichen Daten notwenig sein. Nicht-Ortstreue bedeutet dabei, dass die Magnetfeldkomponenten nicht im selben Raumvolumen erfasst werden.

Ferner könnte - sofern notwendig - eine Skalierung der gemessenen Magnetfeldkomponenten mittels einer zuvor erstellten Tabelle oder Korrekturfunktion erfolgen. Dies wird regelmäßig erforderlich sein, wenn der Sensor, bzw. die Komponente selbst nicht-lineares Verhalten oder eine Querempfindlichkeit zu Nebenkomponenten aufweist. Weiterhin kann aus den einzelnen Vektorkomponenten der Magnetfeldbetrag gebildet werden. Optional kann auch eine grafische Darstellung der Magnetfeldkomponente oder -Komponenten in Abhängigkeit des Messortes und/oder weiterer Einflüsse (z. B. des Stroms) erzeugt werden. Je nach Aufgabenstellung kann eine Untersuchung der grafischen Darstellung nach subjektiven und/oder objektiven Auffälligkeiten, z. B. bei einer Defektanalyse, im Rahmen einer Qualitätssicherungsmaßnahme erfolgen.

Sofern Daten von derselben Batterie bei derselben Fixierung vorliegen, können weitere Vergleiche mit unterschiedlichen Messungen für gleiche oder veränderte Betriebszustände der Batterie (SOC, Strom, Temperatur etc.) durchgeführt werden.

Die Erfindung lässt sich wie folgt zusammenfassen. Es wurde festgestellt, dass sich die magnetische Permeabilität für unterschiedliche Lithiumgehalte im Kathodenmaterial sehr stark ändert. Das erfindungsgemäße Verfahren nutzt den physikalischen Zusammenhang zwischen Strom, magnetischer Suszeptibilität und Magnetfeldstärke (Biot-Savart-Gesetz, Maxwell-Gleichungen). Ferner nutzt es eine definierte, hinreichend kurze, induzierte, elektrische Strom-Stimulanz (z. B. direkt mittels Netzteil, optisch, etc.), um die elektrisch relevanten Werte (Stromfluss, Spannung, Pulszeit) und Magnetfeldvektoren oder Komponenten desselben an einem oder mehreren Messpunkten (Zustände) in der zugänglichen Umgebung um das Prüfobjekt zu erfassen. Es folgt gegebenenfalls eine Korrektur der Messwerte hinsichtlich der Skalierung und/oder der Absolut-Relativ-Positionierung.

Der örtliche und/oder zeitliche Vergleich der erhaltenen Magnetfelddaten unter Berücksichtigung der erfassten, elektrischen Parameter und der Relevanz (Ortsbezug, 'Reichweite' des Magnetfeldes aufgrund eines lokal induzierten Stromes unter Berücksichtigung der Sensorauflösung, physikalischen Limits, geometrischen Aufbaus, Messposition) führt zu einer qualitativen Einschätzung des Ladezustandes und gegebenenfalls auch des Gesundheitszustandes der untersuchten Batterie.

Das vorgenannte erfindungsgemäße Verfahren ist auf die Charakterisierung von Prüfkörpern in Form von Batterien beschränkt.

Spezieller Beschreibungsteil

Nachfolgend werden der erfindungsgemäße Messaufbau und ein Verfahren zur örtlichen Erfassung wenigstens eines Magnetfeldvektors in Kombination einer synchronisierten Strom-Stimulanz näher erläutert. Er dient dazu, zerstörungsfrei nähere Informationen zu einer Batterie, insbesondere zu einer Li-Ionen-Batterie zu erhalten, und kann beispielsweise im Vorfeld der erfindungsgemäßen Untersuchungen zu einer Vorauswahl eines geeigneten Messortes in Bezug auf das Prüfobjekt führen. Ferner werden Methoden zur Ermittlung eines Kennfeldes, bzw. von Referenzmessungen zur Bestimmung des Ladungszustandes einer Li-Ionen Batterie beschrieben.

Dazu erfolgt die Messung des externen Magnetfelds einer Li-Ionen-Batterie in Abhängigkeit des Ladezustands (engl.: state of charge, SOC) und/oder die Messung des externen Magnetfelds einer gegebenenfalls auch gezielt lokal geschädigten Li-Ionen-Batterie.

Die Auswertung der experimentellen magnetischen Daten in Kombination mit weiteren relevanten Parameter (z. B. Magnetfeldstärke, elektrische Parameter, Zeit) hierzu in einer Vorrichtung zur Messdatenaufbereitung, lassen daraus qualitative Rückschlüsse auf den Gesundheitszustandes (engl.: state of health, SOH) sowie Kenntnisse über physikalische und chemische Vorgänge innerhalb der Batterie zu. Auch lokale Beschädigungen lassen sich damit qualitativ erkennen.

In den nachfolgend vorgestellten Ausführungsbeispielen wurde dazu eine mehrschichtig aufgebaute, planare Leistungs-Li-Ionen Batterie verwendet. Es wird davon ausgegangen, dass die Schichten sich nicht zu stark voneinander unterscheiden, d. h. sich ihre Eigenschaften ähneln.

Es wurden folgende Untersuchungen an der Li-Batterie mit entsprechenden Ergebnissen durchgeführt.

I. Korrelation des Ladezustands (SOC) mit der Magnetfeldstärke

Bei diesem Ausführungsbeispiel sollte gezeigt werden, dass mit Hilfe nur eines Messortes an geeigneter Stelle (gleichbedeutend einem fixierten Magnetfeldsensor) oder mit Hilfe der

Mittelwertbildung eine Korrelation mit dem Ladezustand (SOC) der Batterie beobachtet werden kann.

Im vorliegenden Fall wurde das Magnetfeld der Batterie nur auf einer Oberfläche mit Überhang mittels obigen Ablauf für 3 verschiedene Ladezustände (SOC), d. h. hier Leerlaufspannungs (engl.: open-circuit voltage, OCV)-Zustände ermittelt.

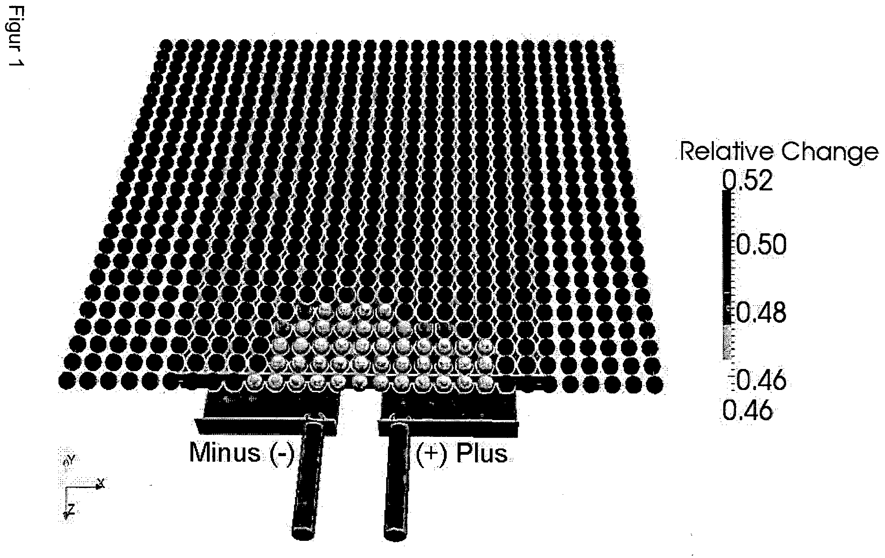

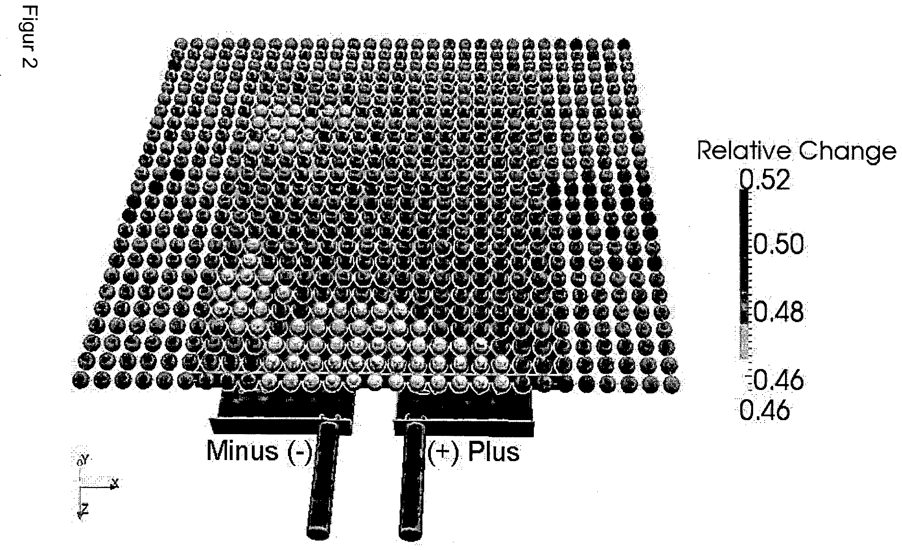

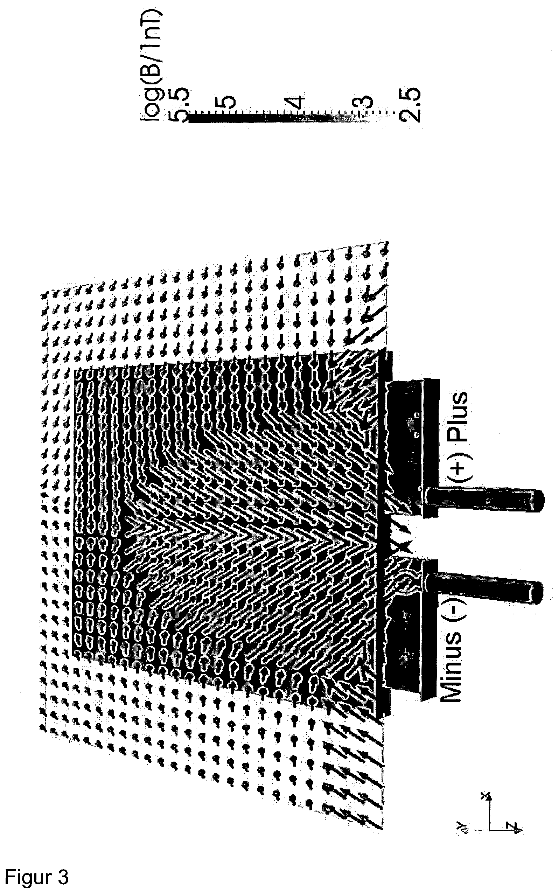

Abgebildet sind in den Figuren 1 bis 3 jeweils die Beträge des gemessenen, äußeren Magnetfelds einer Batterie während eines Entladevorgangs, d. h. die technische Stromrichtung ist positiv bezüglich des äußeren Stromkreises (Strom von + nach -) und negativ für den Stromfluss innerhalb der Batterie (Strom von - nach +). Somit sind die beobachteten Vektoren konform zur theoretischen Ausrichtung (Rechte-Faust-Regel, Korkenzieherregel).

Figur 1 zeigt die Nichtlinearität des Magnetfelds für einen Ladungszustand (SOC) gegen 0 %. Das Kathodenmaterial zeigt paramagnetisches Verhalten, B ist eine Funktion von H (Langevin-Funktion, Brillouin-Funktion).

Figur 2 zeigt die Nichtlinearität des Magnetfelds für einen Ladungszustand (SOC) von 90 %. Das Kathodenmaterial zeigt nahezu diamagnetisches Verhalten, B ist keine Funktion von H.

In Figur 3 ist das äußere Magnetfeld (Betrag und Richtung) einer Li-Ionen Batterie für einen Ladungszustand von 90 % für einen konstanten Strom I dargestellt. Es ist zu beachten, dass die gemessenen Magnetfeldwerte über 3 Dekaden variieren, so dass für diese Art Untersuchungen ein Magnetfeldsensor mit einem entsprechenden Dynamikbereich eingesetzt werden sollte.

Aus der Beziehung B ~ I * $\mu$ geht hervor, dass sich bei konstantem I das Magnetfeld B nur dann ändern kann, wenn dies über $\mu$ geschieht. Aus [1] ist bekannt, dass das Kathodenmaterial $LiCoO_2$ im tiefentladenen Zustand der Batterie eine geringe magnetische Suszeptibilität in der Größenordnung $\pm$ $10^{-4}$ aufweist, während es im geladenen Zustand der Batterie dagegen eine hohe magnetische Suszeptibiltät in der Größenordnung um $10^{-4}$ aufweist.

Unter der Annahme, dass das Kathodenmaterial in der Batterie einen weitestgehend homogenen Zustand aufweist, ist bei einer Summierung bzw. Mittelung aller gemessenen Magnetfeldvektoren daher ein Unterschied zwischen geladenem und ungeladenem Zustand der Batterie zu erwarten. Dies wurde für die hier untersuchte Li-Batterie bestätigt, wie die folgenden Messergebnissee zeigen, und die mit den Beobachtungen aus [1] korrelieren:

| SOC | 10 % | 50 % | 90 % |
|---|---|---|---|
| gemitteltes \|B\|, in u. a. | 13,375 | 15,243 | 15,222 |

u. a. bedeutet hier in willkürlichen Einheiten. Hierbei ist zu beachten, dass die gemessenen Magnetfeldwerte, d. h sowohl die Magnetfeldkomponenten als auch die Magnetfeldbeträge, für einen bestimmten Messort aufgrund der Empfindlichkeit des Sensors und der Relation:

$$\mathbf{B}\left(\mathbf{P}\right) = \frac{\mu_0\,\mathbf{I}}{4\,\pi} \int \frac{\mathrm{d}s}{\mathbf{r}_{\overline{PQ}}^2} \times \frac{\mathbf{r}_{\overline{PQ}}}{\left\|\mathbf{r}_{\overline{PQ}}\right\|}$$

mit dem Magnetfeldsensor an der Stelle P, I dem Strom(vektor) an der Stelle Q, ds dem finit großen Längenelement des Stromvektors I, $r_{PQ}$ dem örtlichen Abstandsvektor zwischen Punkt P und Q und mit $\mu$ der Permeabilität (hier ohne Materialeinfluss, daher $\mu_0$), aus unterschiedlichen Orten stammen kann.

Damit ist folgendes gemeint. Befindet sich ein Ort Q außerhalb der Detektionsgrenze, das bedeutet, dass der Abstand $r_{PQ}$ zu groß ist, um im Sensorgesamtsignal eine signifikante Änderung zu bewirken, kann bei gleichem Strom, aber am Punkt Q lokal erhöhtem $\mu$ das Magnetfeld am Punkt P stark genug werden, um doch einen signifikanten Beitrag zum Gesamtsignal zu liefern.

II. Lokalisierter Einfluss der Suszeptibilität- und/oder Stromdichteänderungen

Mit diesem Ausführungsbeispiel sollte gezeigt werden, dass verschiedene Effekte, wie beispielsweise die Suszeptibilität oder die Stromdichteverteilungsänderung, qualitativ unterschieden werden können.

Anhand ein und derselben Batterie im gleichen Ladungszustand (OCV) wird eine Änderung der Stromdichteverteilung durch eine kleine örtliche Verschiebung ohne Korrektur des Referenzpunktes an der Batterie vor (Zustand 1) und nach (Zustand 2) wiederholtem Einbau simuliert. Die Verschiebung, bzw. Verkippung der Batterie beträgt dabei in allen Raumrichtungen weniger als 1 mm. Der Messstrom wurde für beide Messungen konstant gehalten.

III. Defektlokalisierung

Anhand dieses Ausführungsbeispiels soll gezeigt werden, dass eine Schädigung der Batterie im äußeren Magnetfeld mit Hilfe der Magnetographie abgebildet und zudem vorteilhaft lokal eingegrenzt werden kann.

Zu diesem Zweck wurde in Anlehnung an die Nagelprobe (nail penetration test) eine Batterie mit Nägeln aus elektrisch isolierendem Material durchschlagen. Anschließend wurde geprüft, ob die Batterie noch Restkapazität aufweist. Wäre diese nahe null, wäre die Schädigung zu stark gewesen. Im vorliegenden Fall wurde eine zwar reduzierte, aber stabile OCV gemessen.

Somit wurde eine Messung mit Ladestrom durchgeführt. Ein unmittelbar sichtbarer Einfluss auf das gemessene Magnetfeld konnte nicht ausgemacht werden. Eine Auswertung der $B_x$-Komponente bezüglich der Nachbarwerte mittels Quotientenbildung zeigt jedoch Auffälligkeiten.

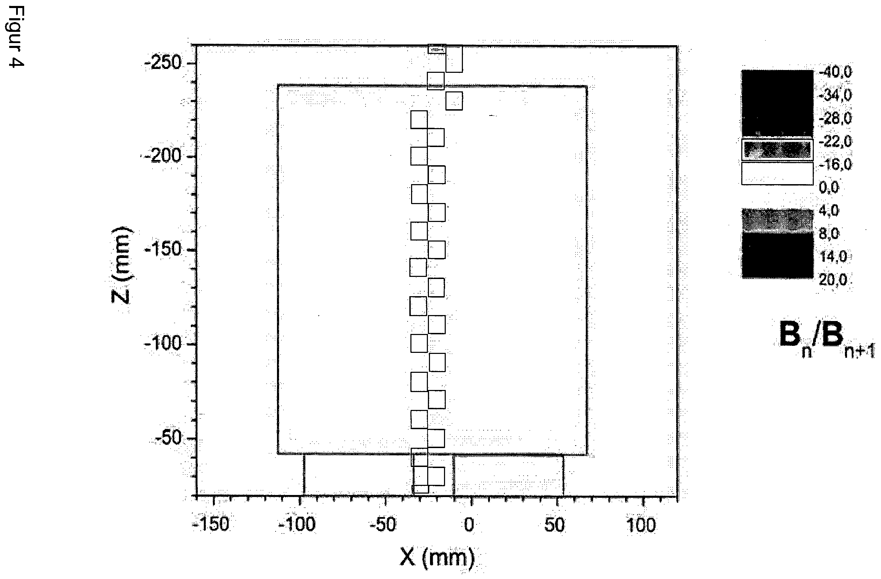

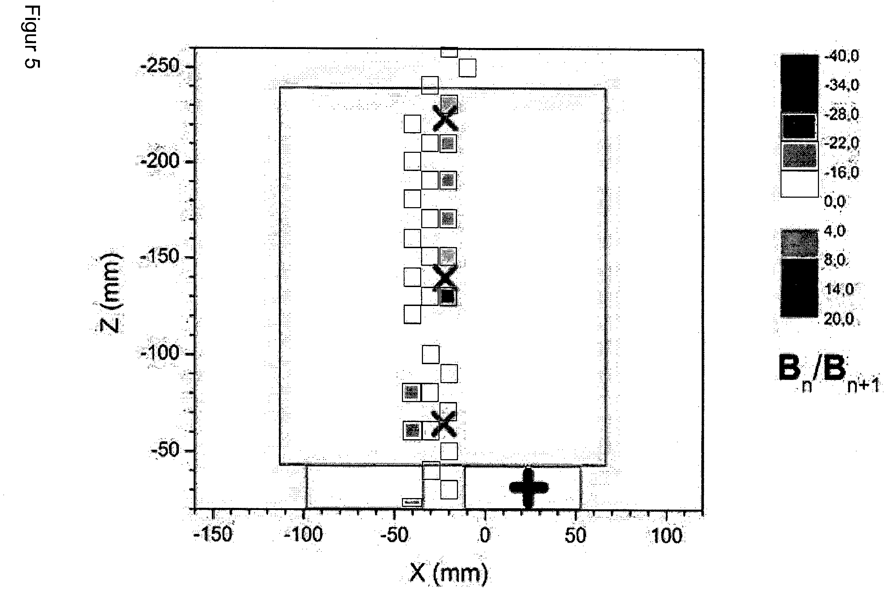

Die Figuren 4 und 5 zeigen den örtlichen Gradienten einer Magnetfeldkomponente bezüglich eines Nachbarortes bei einer ungeschädigten (Figur 4) Batterie für einen konstanten Strom I (hier 10 A). In Figur 5 sind im Unterschied dazu die örtlichen Gradienten einer Magnetfeldkomponente bezüglich eines Nachbarortes bei einer geschädigten Batterie für einen konstanten Strom I (hier 10 A) dargestellt.

IV. Aufnahme von Referenzspektren zum Ladungszustand

Zur Erstellung einer Referenzmessung für den Zusammenhang zwischen Ladungszustand (SOC) der zu vermessenden Li-Ionen Batterie und der gemessenen Magnetfeldstärke gibt es zwei mögliche Methoden:

- SOC-Bestimmung einer Li-Ionen Batterie mittels der Bestimmung der Linearität der magnetischen Suszeptibilität.
- SOC-Bestimmung einer Li-Ionen Batterie mittels der Bestimmung der gemittelten magnetische Suszeptibilität in Abhängigkeit des Stromes I und des SOC, d. h. über den Betrag des magnetischen Feldes B.

Es ist bereits eine Vielzahl von Lithium-haltigen Batterien bekannt, die aus diversen Aktivelektrodenmaterialien aufgebaut sein können. Die Kathode besteht zum Beispiel aus einem Lithiummetallschichtoxid (z.B.: $LiNiO_2$, $LiCoO_2$, $LiMnO_2$, $LiNi_{1/3}Co_{1/3}Mn_{1/3}O_2$ - $LiNi_{x-(y+z+n)}CO_{y-(x+z+n)}Al_{z-(x+y+n)}Mn_{n-(x+y+z)}O_2$, mit x = 0..1, y = 0..1, z = 0..1, n = 0..1), einem Lithiummetallphosphat (z.B.: $LiFePO_4$, $LiCoPO_4$, $LiMnPO_4$, $LiFe_{x-(y+z+n)}Ni_{y-(x+z+n)}CO_{z-(x+y+n)}Mn_{n-(x+y+z)}PO_4$, mit x = 0..1, y = 0..1, z = 0..1, n = 0..1) oder einem Lithiummetallspinell (z. B.: $LiMn_2O_4$, $Li-Ni_{0.5}Mn_{1.5}O_4$, $Li-Ni_{x-(y+z+n)}Co_{y-(x+z+n)}Fe_{z-(x+y+n)}Mn_{n-(x+y+z)}O_4$, mit x = 0..2, y = 0..2, z = 0..2, n = 0..2). Die Anode besteht zum Beispiel aus Graphit, $Li_4Ti_5O_{12}$, $Li_{4.4}Si$, Si, $Li_{4.4}Sn$ oder Sn. Die Aktivelektrodenmaterialien können rein oder als Komposit mit herkömmlichen Leitfähigkeitsadditiven und Bindern verarbeitet sein. Als Stromkollektoren können Metallfolien aus Cu, Al, Stahl, Graphit oder Ni eingesetzt werden. Die Stromabgriffe können aus Ni, Cu, Stahl oder einem ähnlichen Material bestehen. Als Separatoren sind Polymere oder auch Keramiken bekannt. Die Batteriehülle besteht z.B. aus einer Polymerfolie. Die Kapazität der zu vermessenden Li-Ionen Batterie liegt zwischen 1 mAh und 100 Ah (z. B. 10 mAh, 1 Ah oder 40 Ah). Die Bauform der Li-Ionen Batterie kann prismatisch, zylindrisch oder der Pouchbagart sein.

Die Lade- und Entladeströme der Li-Ionen Batterie, bei denen die Messung erfolgt, dürfen die im Datenblatt angegebenen Grenzen nicht überschreiten. Es können z. B. 0 C (die C-Rate gibt den auf die Kapazität Q der Li-Ionen Batterie bezogenen Lade- bzw. Entladestrom I an und gibt Auskunft über die Lade- bzw. Entladezeit

$$t - C_{rate} = \frac{I}{Q} = \frac{1}{t}, [h^{-1}]$$

), 0,01 C, 0,1 C, 0,5 C, 1 C, 2 C, 5 C oder 10 C als Lade- bzw. Entladestrom eingesetzt werden. Für eine Batterie mit 2 Ah betragen die entsprechenden Ströme z. B.: 0 A, $\pm$ 20 mA (0,01 C), $\pm$ 200 mA (0,1 C), $\pm$ 1 A (0,5 C), $\pm$ 2 A (1 C), $\pm$ 4 A (2 C), $\pm$ 10 A (5 C) und $\pm$ 20 A (10 C).

A. Bespiel für die Erstellung einer Referenz für die SOC-Bestimmung einer Li-Ionen Batterie mittels der Bestimmung der Linearität der magnetischen Suszeptibilität in Abhängigkeit des SOC

Die Messung basiert darauf, an mindestens einem örtlich festgelegten Messpunkt mit dem beschriebenen Sensortyp das B-Feld in Abhängigkeit des bekannten SOC und der bekannten Messstrompulsstärke I für die zu untersuchende Li-Ionen Batterie zu bestimmen.

Die Erstellung der Referenz erfolgt beispielsweise durch:

1) Einstellen der Li-Ionen Batterie auf einen definierten SOC. Der Ladungszustand wird bestimmt durch Abgleich von offener Zellspannung ($U_{OCV}$) mit Datenblatt, alternativ über Spannung bei niedrigen Strömen, zum Beispiel bei 0.1 C, alternativ über Integration des Stromes über die Zeit (Farraday-Methode) mittels Integration des Stromes (Q = I dt bei I = konst.).

a) Laden auf einen SOC von 100 %: Durch Anlegen eines konstanten Stromes (z. B. zwischen 20 mA und 20 A) bis auf die im Datenblatt angegebene Ladeschlussspannung (z. B. 1 V bis 5.0 V) und durch anschließende Ladung bei konst. Spannung (z. B. 1 V bis 5.0 V) für eine Zeit von beispielsweise 10 min. bis 10 h.

b) Entladen auf einen SOC von 0 %: Durch Anlegen eines konstanten Stromes (z. B. zwischen -20 mA und -20 A) bis auf die im Datenblatt angegebene Entladeschlussspannung (z. B. 1 V bis 4,0 V) und durch anschließende Entladung bei konst. Spannung (z. B. 1 V bis 4,0 V) für eine Zeit von beispielsweise 10 min bis 10 h.

2) Messung des B-Feldes nach der vorher beschriebenen Weise unter Anlegen von mindestens 3 verschiedenen Messstrompulsen I (z. B.: 0 C, 0,01 C, 0,1 C, 0,5 C, 1 C, 2 C, 5 C) für eine kurze der Messdauer des B-Feldes entsprechenden Messzeit $t_{mess}$ (z. B.: 1 ms bis 1s) woraus man drei von den Messstrompulsen abhängige B-Feldwerte erhält (siehe Figur 4). Das Integral von I und $t_{mess}$ sollte weniger als 1 % der Gesamtkapazität der Li-Ionen Batterie betragen (z. B. 0.1 %).

3) Änderung des SOC durch Laden oder Entladen der Batterie auf einen definierten SOC.

a) Entladen auf einen SOC von 90 % ($\Delta$SOC = 10% - Schritte im $\Delta$SOC zum Beispiel auch 0,1 %, 1 %, 5 %, 10 %, 50 %):

- Durch Anlegen eines konstanten Stromes (z. B. zwischen 0,01 C und 1 C) für ein definiertes Zeitintervall (zwischen 10 h und 0.1 h), womit durch Integration des Stromes der angestrebte SOC erreicht wird.
- Durch Anlegen eines konstanten Stromes (z. B. zwischen 0.01 C und 5 C) bis eine Spannung U (z. B.: 4 V) erreicht wird, die nach dem Datenblatt der Li-Ionen Batterie dem angestrebten SOC entspricht.
- Durch Anlegen eines konstanten Stromes (z. B. zwischen 0.01 C und 5 C) bis eine Spannung U (z. B.: 4 V) erreicht wird, die nach dem Datenblatt der Li-Ionen Batterie dem angestrebten SOC entspricht und durch anschließende Entladung bei konst. Spannung (z.B. 1 V bis 4,0 V) für eine Zeit von beispielsweise 10 min bis 10 h.

b) Laden auf einen SOC von 10 % ($\Delta$SOC = 10% - Schritte im $\Delta$SOC zum Beispiel auch 0,1 %, 1 %, 5 %, 10 %, 50 %):

- Durch Anlegen eines konstanten Ladestromes (z.B. zwischen 0,01 C und 1 C) für ein definiertes Zeitintervall (zwischen 10 h und 0,1 h), womit durch Integration des Stromes der angestrebte SOC erreicht wird.
- Durch Anlegen eines konstanten Ladestromes (z. B. zwischen 0,01 C und 5 C) bis eine Spannung U (z. B.: 4 V) erreicht wird, die nach dem Datenblatt der Li-Ionen Batterie dem angestrebten SOC entspricht.
- Durch Anlegen eines konstanten Ladestromes (z. B. zwischen 0,01 C und 5 C) bis eine Spannung U (z. B.: 4 V) erreicht wird, die nach dem Datenblatt der Li-Ionen Batterie dem angestrebten SOC entspricht und durch anschließende Entladung bei konst. Spannung (z.B. 1 V bis 4,0 V) für eine Zeit von beispielsweise 10 min bis 10 h.

4) Wiederholung von Punkten b) und c) je nachdem, wie groß der $\Delta$SOC definiert wurde.

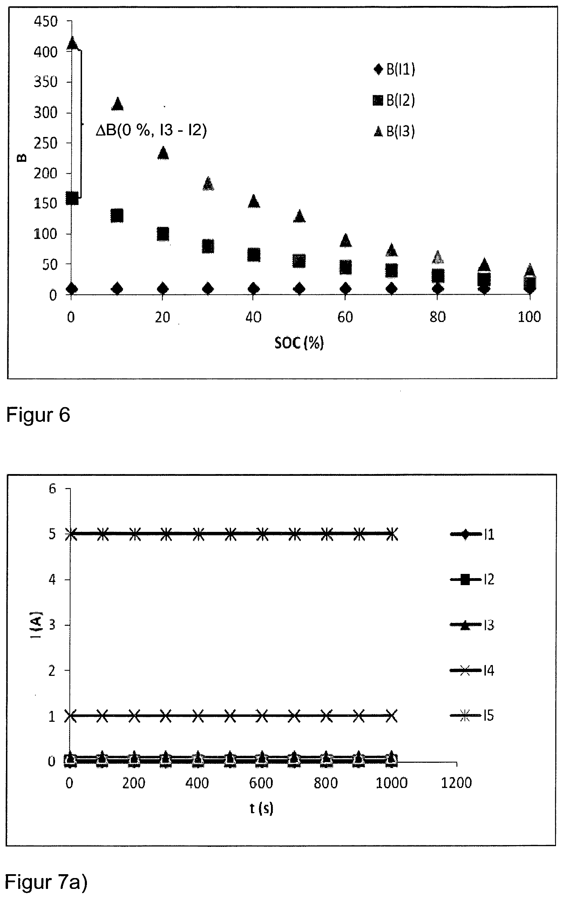

Die Figur 6 zeigt ein Beispiel für den Verlauf der B-Feldstärke (in relativen Größen) in Abhängigkeit des Ladungszustandes (SOC) für verschiedene Stromstärken

B. Beispiel für die Erstellung einer Referenz für die SOC-Bestimmung einer Li-Ionen Batterie mittels der Bestimmung der scheinbaren magnetischen Suszeptibilität in Abhängigkeit des Stromes I und des SOC

Die Messung basiert darauf, an mindestens einem Messpunkt mit dem beschriebenen Sensortyp das B-Feld in Abhängigkeit eines bekannten Startladungszustandes ($SOC_0$) und einer konstanten, bekannten Messstromstärke (I) für eine bestimmte Zeit (t) die zu untersuchende Li-Ionen Batterie zu bestimmen (siehe Kapitel Messungen und Auswertung).
Die Erstellung der Referenz erfolgt beispielsweise durch:

1) Einstellen der Li-Ionen Batterie auf einen definierten $SOC_0$. Der Ladungszustand wird bestimmt durch Abgleich von offener Zellspannung ($U_{OCV}$) mit Datenblatt, alternativ über Spannung bei niedrigen Strömen, zum Beispiel bei 0,1 C, alternativ über Integration des Stromes über die Zeit mittels Integration des Stromes (Q = I dt bei I = konst.).

a) Laden auf einen SOC von 100 %: Durch Anlegen eines konstanten Stromes (z. B. zwischen 20 mA und 20 A) bis auf die im Datenblatt angegebene Ladeschlussspannung (z. B. 1 V bis 5,0 V) und durch anschließende Ladung bei konst. Spannung (z. B. 1 V bis 5,0 V) für eine Zeit von beispielsweise 10 min bis 10 h.
b) Entladen auf einen SOC von 0 %: Durch Anlegen eines konstanten Stromes (z. B. zwischen -20 mA und -20 A) bis auf die im Datenblatt angegebene Entladeschlussspannung (z. B. 1 V bis 4.0 V) und durch anschließende Entladung bei konst. Spannung (z. B. 1 V bis 4,0 V) für eine Zeit von beispielsweise 10 min bis 10 h.

2) Messung des B-Feldes in Intervallen t von beispielsweise 10 s (zwischen 1 ms und 100 min) nach der vorbeschriebenen Weise bei mindestens zwei verschiedenen konstanten Messströmen I von beispielsweise 0,1 C (auch:

0 C, 0,01 C, 0,1 C, 0,5 C, 1 C, 2 C, 5 C) woraus man mindestens zwei von den Messströmen abhängige B-Feldwertverläufe erhält (siehe Figur 5).

3) Zur Auswertung des bei den aufgenommenen B-Feldern herrschenden SOC wird der Messstrom über die Intervalldauer t integriert, z. B. 10 s x 0.1 C --> pro Intervall beträgt der ΔSOC 0,027 %.

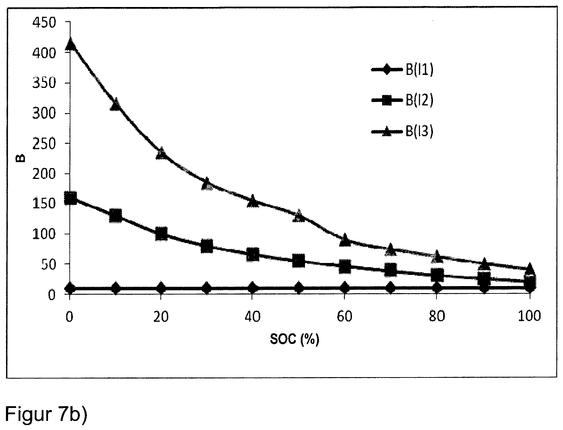

Die beiden Abbildungen der Figur 7 zeigen in 7a) den Stromverlauf in Abhängigkeit der Zeit mit eingezeichneten Messsignalen für verschiedene Stromstärken und in 7b) das B-Feld für verschiedene Ströme in Abhängigkeit des Ladungszustandes (SOC) der gemessenen LiIonen Batterie.

In der Anmeldung zitierte Literaturstellen:

[1] J. T. Hertz, Q. Huang, T. McQueen, T. Klimczuk, J. W. G. Bos, L. Viciu, R. J. Cava, Magnetism and structure of LixCoO2 and comparison to NaxCoO2, Phys. Rev. B 77(7), 075119 (2008).

[2] Qi Zhang, Qingzhi Guo, Ralph E, White, Journal of Power Sources, Volume 165, Issue 1, 25 February 2007, Seiten 427- 435.

[3] Karl-Heinz Hauer, Roland Potthast, Thorsten Wüster, Detlef Stolten, Magnetotomography - a new method for analysing fuel cell performance and quality, Journal of Power Sources, Volume 143, Issues 1-2, 27 April 2005, Pages 67-74.

## Patentansprüche

1. Verfahren zur qualitativen Bestimmung des Betriebszustandes eines Prüfobjektes in Form einer Batterie mit Hilfe der Messung des magnetischen Feldes, wobei das magnetische Feld B nur durch den inneren Stromfluss des Prüfobjekts selbst erzeugt wird, mit den Schritten:

   a. das Prüfobjekt wird elektrisch kontaktiert,
   b. wenigstens ein Magnetfeldsensor, der zumindest eine Komponente eines Magnetfeldes erfassen kann, wird derart in der Nähe des Prüfobjektes angeordnet und in Bezug auf das Prüfobjekt fixiert, dass der Magnetfeldsensor das vom Prüfobjekt erzeugte Magnetfeld zu messen vermag,
   **dadurch gekennzeichnet,**
   c. **dass** das Prüfobjekt für einen Messpunkt in wenigstens zwei unterschiedliche Zustände i = 1, 2,.. versetzt wird, die sich im Gesamtstrom $I_i$ voneinander unterscheiden, und für jeden Zustand i zu dem Strom $I_i$ wenigstens eine Magnetfeldkomponente des magnetischen Feldes $B_i$ mit Hilfe des Magnetfeldsensors ermittelt wird,
   d. **dass** für jeden Zustand i der Quotient $Q_i$ aus Magnetfeld, bzw. Magnetfeldkomponente $B_i$ zu Gesamtstrom $I_i$ gebildet wird, der näherungsweise proportional zur magnetischen Suszeptibilität $\chi$ ist,
   e. **dass** ferner die Steigung aus jeweils zwei Wertepaaren wie folgt ermittelt wird:

$$m_{i,j} = \Delta(Q_i, Q_j) / \Delta(I_i, I_j)$$

   mit $i \neq j$ und i, j = einzelne Stromzustände, und
   f. **dass** aus den so erhaltenen Steigungen $m_{ij}$ auf den Betriebszustand des Prüfobjektes geschlossen wird.

2. Verfahren nach vorhergehendem Anspruch, bei dem als Prüfobjekt eine Lithium-Ionen-Batterie eingesetzt wird.

3. Verfahren nach einem der vorhergehenden Ansprüche, bei dem der Magnetfeldsensor fest mit dem Prüfobjekt verbunden ist.

4. Verfahren nach einem der vorhergehenden Ansprüche, bei dem ein Magnetfeldsensor eingesetzt wird, der die x-, y- und z-Komponente des magnetischen Feldes B erfassen kann, und insbesondere ein 3D-AMR-Sensor als Magnetfeldsensor eingesetzt wird.

5. Verfahren nach einem der vorhergehenden Ansprüche, bei dem die Gesamtmesszeit für die Messungen des magnetischen Feldes der unterschiedlichen Zustände i einer Messreihe für einen Messpunkt weniger als 1 Minute beträgt, und vorteilhaft die Messzeit für die Messungen des magnetischen Feldes im Bereich von 1 ms bis zu einigen Sekunden beträgt.

6. Verfahren nach einem der vorhergehenden Ansprüche, bei dem zu einem Zustand i neben dem Strom $I_i$ und dem

magnetischen Feld $B_i$ zusätzlich der Messzeitpunkt erfasst wird.

7. Verfahren nach einem der vorhergehenden Ansprüche, bei dem nach Versetzen des Prüfobjektes in einen Zustand i und vor einer Messung eine Wartezeit zur Einstellung des thermischen, elektronischen und/oder mechanischen Gleichgewichts vorgesehen ist.

8. Verfahren nach vorhergehendem Anspruch, bei dem das Prüfobjekt für wenigstens zwei Messpunkte in jeweils unterschiedliche Zustände i versetzt wird,

   - wobei sich die Zustände i innerhalb eines Messpunktes unterscheiden und von Messpunkt zu Messpunkt identisch sind, und
   - wobei zwischen den wenigstens zwei Messpunkten jeweils ein zeitlicher Abstand von wenigstens dem 3-fachen der Messzeit eingehalten wird.

9. Verfahren nach vorhergehendem Anspruch, bei dem aus dem Vergleich der Steigungen zwischen den Messpunkten auf den Ladezustand des Prüfobjektes geschlossen wird.

10. Verfahren nach Anspruch 9, bei dem das Prüfobjekt für einen Messpunkt in wenigstens drei unterschiedliche Zustände i versetzt wird, und aus dem Vergleich der Steigungen auf den Ladezustand des Prüfobjektes geschlossen wird.

11. Verfahren nach einem der vorhergehenden Ansprüche, bei dem eine Referenzmessung hinterlegt ist, und durch Vergleich der ermittelten Steigungen mit einer Referenz auf den absoluten Ladungszustand geschlossen wird.

12. Vorrichtung zur qualitativen Bestimmung des Betriebszustandes eines Prüfobjektes in Form einer Batterie,

   - mit wenigstens einem Magnetfeld-Sensorsystem, umfassend wenigstens einen Magnetfeldsensor, der wenigstens eine Komponente des Magnetfeldes B erfassen kann,
   - mit einem elektrischen Sensorsystem, umfassend wenigstens einen Stromsensor,
   - mit einem Mittel zur Aufnahme und Fixierung des Prüfobjektes,
   - mit einer Datenerfassungs- und Datenauswerteeinheit, und
   - mit einem Stromstimulanzsystem zum Einstellen verschiedener elektrischer Betriebszustände des Prüfobjektes, *dadurch gekennzeichnet,*
   **dass** die Vorrichtung dazu eingerichtet ist, das Verfahren nach einem der vorhergehenden Ansprüche 1 bis 11 durchzuführen.

13. Vorrichtung nach Anspruch 12, mit einem Mittel zur Aufnahme wenigstens eines Magnetfeldsensors, derart, dass eine Relativbewegung zwischen dem Prüfobjekt und dem Magnetfeldsensor während einer Messung ausgeschlossen ist.

14. Vorrichtung nach einem der vorhergehenden Ansprüche 12 bis 13, bei dem das elektrische Sensorsystem zusätzlich ein Filtersystem zum Minimieren von Störeinflüssen aufweist und/oder ein System zur Konvertierung des Sensorsignals aufweist und/oder zusätzlich ein System zur Erfassung der Betriebsparameter des Stromsensors zur Korrekturmöglichkeit der Messergebnisse aufweist.

15. Vorrichtung nach einem der vorhergehenden Ansprüche 12 bis 14, mit einem Magnetfeldsensor-Array.

16. Vorrichtung nach einem der vorhergehenden Ansprüche 12 bis 15, bei dem zusätzlich ein Positioniersystem für wenigstens einen Magnetfeldsensor des Magnetfeldsensorsystems vorgesehen und/oder ein zusätzliches Stromstimulanzsystem mit dem Messaufbau vorgesehen ist, welches verschiedene elektrische Betriebszustände des Prüfobjektes einzustellen vermag.

17. Vorrichtung nach einem der vorhergehenden Ansprüche 12 bis 16, mit einem Datenspeichersystem zur Erfassung der von dem Magnetfeld-Sensorsystem und dem elektrischen Sensorsystem ermittelten Daten.

**Claims**

1.  Method for the qualitative determination of the operational state of a test object in the form of a battery with the aid of the measurement of the magnetic field, wherein the magnetic field B is produced only by the internal current flow of the test object itself, with the steps:

    a. An electrical contact is established with the test object,
    b. at least one magnetic field sensor, which can detect at least one component of a magnetic field, is arranged in the proximity of the test object, and fixed in relation to the test object, in such a way that the magnetic field sensor is capable of measuring the magnetic field produced by the test object,
    ***characterized in that***
    c. the test object is displaced for a measuring point in at least two different states i = 1, 2,..., which differ from one another in the total current $I_i$, and for each state i of the current $I_i$ at least one magnetic field component of the magnetic field $B_i$ is determined with the aid of the magnetic field sensor,
    d. for each state i the quotient $Q_i$ from the magnetic field or magnetic field component $B_i$ respectively is formed to the total current $I_i$, which is approximately proportional to the magnetic susceptibility $\chi$,
    e. that additionally the gradient from two value pairs in each case is determined as follows:

    $$m_{ij} = \Delta(Q_i, Q_j) / \Delta(I_i, I_j)$$

    with $i \neq j$ and 1, j = individual current states, and
    f. from the gradients $m_{ij}$ obtained in this way, conclusions can be drawn with regard to the operational state of the test object.

2.  Method according to the preceding claim, in which a lithium-ion battery is used as the test object.

3.  Method according to any one of the preceding claims, in which the magnetic field sensor is securely connected to the test object.

4.  Method according to any one of the preceding claims, in which a magnetic field sensor is used which can detect the x-, y- and z-components of the magnetic field B, and in particular a 3D-AMR sensor is used as the magnetic field sensor.

5.  Method according to any one of the preceding claims, in which the total measuring time for the measurements of the magnetic field of the different states i of a series of measurements for one measuring point is less than 1 minute, and, advantageously, the measuring time for the measurements of the magnetic field lie in the range from 1 ms to several seconds.

6.  Method according to any one of the preceding claims, in which, for a state i, as well as the current $I_i$ and the magnetic field $B_i$, the measurement point of time is detected.

7.  Method according to any one of the preceding claims, in which, after the movement of the test object into a state i and before a measurement, a waiting time is provided for the adjustment of the thermal, electronic, and/or mechanical balance.

8.  Method according to any one of the preceding claims, in which the test object is moved, for at least two measuring points, into different states i in each case,

    - wherein the states i within one measuring point differ, and are identical from measuring point to measuring point, and
    - wherein, between the at least two measuring points in each case, a time interval is maintained of at least three times the measuring time.

9.  Method according to the preceding claim, in which, from the comparison of the gradients between the measuring points, a conclusion can be drawn with regard to the charge state of the test object.

10. Method according to claim 8, in which the test object is moved, for one measuring point, into at least three different states i, and from the comparison of the gradients a conclusion can be drawn with regard to the charge state of the test object.

11. Method according to any one of the preceding claims, in which a reference measurement is deposited, and, by comparing the gradients determined with a reference, a conclusion can be drawn with regard to the absolute charge state.

12. Device for the qualitative determination of the operational state of a test object in the form of a battery,

- with at least one magnetic field sensor system, comprising at least one magnetic field sensor, which can detect at least one component of the magnetic field B,
- with an electrical sensor system, comprising at least one current sensor,
- with a means for accommodating and fixing the test object,
- with a data acquisition unit and data evaluation unit, and
- with a current stimulation system for determining different electrical operational states of the test object,
**characterized in that**
the device is configured so as to carry out the method according to any one of the preceding claims 1 to 11.

13. Device according to claim 12, with a means to accommodate at least one magnetic field sensor in such a way that a relative movement between the test object and the magnetic field sensor during a measurement is excluded.

14. Device according to any one of the preceding claims 12 to 13, with which the electrical sensor system additionally comprises a filter system for minimising interference influences and/or a system for detecting the operational parameters of the current sensor for the possibility of correcting the measurement results.

15. Device according to any one of the preceding claims 12 to 14, with a magnetic field sensor array.

16. Device according to any one of the preceding claims 12 to 15, with which a positioning system is additionally provided for at least one magnetic field sensor of the magnetic field sensor system and/or an additional current stimulation system with the measurement set-up, which is capable of adjusting different electrical operating states of the test object.

17. Device according to any one of the preceding claims 12 to 16, with a data storage system for detecting the data derived from the magnetic field sensor system and the electrical sensor system.

**Revendications**

1. Procédé de détermination qualitative de l'état de fonctionnement d'un objet à contrôler sous la forme d'une batterie à l'aide de la mesure du champ magnétique, dans lequel on produit le champ B magnétique seulement par le flux de courant intérieur de l'objet à contrôler, comprenant les stades :

a. on contacte électriquement l'objet à contrôler,
b. on met un capteur de champ magnétique, qui peut détecter au moins une composante d'un champ magnétique, à proximité de l'objet à contrôler, et on l'immobilise par rapport à l'objet à contrôler de manière à ce que le capteur de champ magnétique puisse mesurer le champ magnétique produit par l'objet à contrôler,
**caractérisé**
c. **en ce que** l'on met l'objet à contrôler pour un point de mesure dans au moins deux états i = 1, 2,... différents, qui se distinguent les uns des autres par le courant $I_1$ total, et, pour chaque état i, on détermine, par rapport au courant $I_i$, au moins une composante du champ magnétique $B_1$ à l'aide du capteur de champ magnétique,
d. **en ce que**, pour chaque état i, on forme le quotient $Q_1$ du champ magnétique ou de la composante $B_1$ du champ magnétique par le courant $I_r$ total, qui est à peu près proportionnel à la susceptibilité $\chi$ magnétique,
e. **en ce qu'**en outre, on détermine la pente à partir de respectivement deux paires de valeurs de la manière suivante : $m_{i,j} = \Delta(Q_i, Q_j) / \Delta(I_i, I_j)$ avec i # j et i,j = divers états de courant, et
f. **en ce que** l'on déduit l'état de fonctionnement de l'objet à contrôler des pentes $m_{ij}$ ainsi obtenues.

2. Procédé suivant la revendication précédente, dans lequel on utilise, comme objet à contrôler, une batterie lithium-ions.

3. Procédé suivant l'une des revendications précédentes, dans lequel le capteur de champ magnétique est relié fixement à l'objet à contrôler.

4. Procédé suivant l'une des revendications précédentes, dans lequel on utilise, comme capteur de champ magnétique, un capteur de champ magnétique, qui peut détecter les composantes x, y et z du champ B magnétique, et notamment un capteur 3D-AMR.

5. Procédé suivant l'une des revendications précédentes, dans lequel le temps de mesure total des mesures du champ magnétique des états i différents d'une série de mesures pour un point de mesure est de moins d'une minute et, avantageusement, le temps de mesure des mesures du champ magnétique est dans la plage 1 ms à quelques secondes.

6. Procédé suivant l'une des revendications précédentes, dans lequel on relève à un état i, outre le courant $I_i$ et le champ $B_1$ magnétique, supplémentairement l'instant de mesure.

7. Procédé suivant l'une des revendications précédentes, dans lequel, après avoir mis l'objet à contrôler dans un état i et avant une mesure, on prévoit un temps d'attente pour établir l'équilibre thermique, électronique et/ou mécanique.

8. Procédé suivant la revendication précédente, dans lequel on met l'objet à contrôler, pour au moins deux points de mesure, dans des états i différents, respectivement,

   - dans lequel les états i sont différents dans un point de mesure et sont identiques d'un point de mesure à l'autre, et
   - dans lequel on maintient, entre les au moins deux points de mesure, respectivement, une distance dans le temps d'au moins le triple du temps de mesure.

9. Procédé suivant la revendication précédente, dans lequel on déduit l'état de charge de l'objet à contrôler de la comparaison des pentes entre les points de mesure.

10. Procédé suivant la revendication 9, dans lequel on met l'objet à contrôler pour un point de mesure dans au moins trois états i différents, et on déduit l'état de charge de l'objet à contrôler de la comparaison des pentes.

11. Procédé suivant l'une des revendications précédentes, dans lequel on met en mémoire une mesure de référence, et on déduit l'état de charge absolu en comparant les pentes déterminées à une référence.

12. Dispositif de détermination qualitative de l'état de fonctionnement d'un objet à contrôler sous la forme d'une batterie,

   - comprenant au moins un système de capteur de champ magnétique comprenant au moins un capteur de champ magnétique, qui peut détecter au moins une composante du champ B magnétique,
   - comprenant un système de capteur électrique, comprenant au moins un capteur de courant,
   - comprenant un moyen de réception et d'immobilisation de l'objet à contrôler,
   - comprenant une unité de détection de données et d'exploitation de données, et
   - comprenant un système de stimulation du courant pour établir des états de fonctionnement électriques différents de l'objet à contrôler,
   **caractérisé**
   **en ce que** le dispositif est conçu pour effectuer les procédés suivant l'une des revendications 1 à 11 précédentes.

13. Dispositif suivant la revendication 12, comprenant un moyen de réception d'au moins un capteur de champ magnétique, de manière à exclure un déplacement relatif entre l'objet à contrôler et le capteur de champ magnétique pendant une mesure.

14. Dispositif suivant l'une des revendications 12 à 13 précédentes, dans lequel le système de capteur électrique a, en outre, un système de filtrage pour minimiser des influences perturbatrices et/ou a un système de transformation du signal du capteur et/ou a, en outre, un système de détection des paramètres de fonctionnement du capteur de courant en vue de pouvoir corriger les résultats de la mesure.

15. Dispositif suivant l'une des revendications 12 à 14 précédentes, comprenant un réseau de capteur de champ magnétique.

16. Dispositif suivant l'une des revendications 12 à 15 précédentes, dans lequel il est prévu, en outre, un système de mise en position d'au moins un capteur de champ magnétique du système de capteur de champ magnétique et/ou un système supplémentaire de stimulation du courant avec la structure de mesure, qui permet d'établir des états de fonctionnement électriques différents de l'objet à contrôler.

17. Dispositif suivant l'une des revendications 12 à 16 précédentes, comprenant un système de mise en mémoire de données pour la détection des données déterminées par le système de capteur de champ magnétique et par le système de capteur électrique.

Figur 1

Relative Change

0.52

0.50

0.48

0.46

0.46

Minus (-)          (+) Plus

Figur 2

Figur 3

Figur 4

Figur 5

EP 2 703 830 B1

Figur 6

Figur 7a)

Figur 7b)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4342100 A1
- US 7550737 B1
- US 7902518 B1
- WO 2012092467 A2
- WO 2009146547 A
- DE 102006035741 A1
- DE 102007044257 A1

**In der Beschreibung aufgeführte Nicht-Patentliteratur**

- **J. T. HERTZ ; Q. HUANG ; T. MCQUEEN ; T. KLIMCZUK ; J. W. G. BOS ; L. VICIU ; R. J. CAVA.** Magnetism and structure of LixCoO2 and comparison to NaxCoO. *Phys. Rev. B,* 2008, vol. 77 (7), 075119
- **QI ZHANG ; QINGZHI GUO ; RALPH E ; WHITE.** *Journal of Power Sources,* 25. Februar 2007, vol. 165 (1), 427-435
- **KARL-HEINZ HAUER ; ROLAND POTTHAST ; THORSTEN WÜSTER ; DETLEF STOLTEN.** Magnetotomography - a new method for analysing fuel cell performance and quality. *Journal of Power Sources,* 27. April 2005, vol. 143 (1-2), 67-74